# EUROPÄISCHE PATENTSCHRIFT

(11) **EP 2 057 928 B1**
(45) Veröffentlichungstag und Bekanntmachung des Hinweises auf die Patenterteilung: **20.02.2013**
(21) Anmeldenummer: 08017798.3
(22) Anmeldetag: 10.10.2008
(51) Int. Cl.: A47L 15/24, B01D 5/00, F28D 20/02, C09K 5/14, A47L 15/42, A47L 15/48, H01L 35/30

(54) **Reinigungsgerät mit Latentwärmespeicher**
Cleaning apparatus with latent heat reservoir
Installation de nettoyage dotée d'un accumulateur thermique latent

(30) Priorität: 09.11.2007 DE 102007053381
(43) Veröffentlichungstag der Anmeldung: 13.05.2009
(73) Patentinhaber: MEIKO Maschinenbau GmbH & Co. KG, 77652 Offenburg (DE)
(72) Erfinder: Peukert, Thomas, Dr. Ing., 77815 Bühl (DE); Gaus, Bruno, Dipl.-Masch. Ing. (FH), 77654 Offenburg (DE); Näger, Thomas, 77652 Offenburg (DE)
(74) Vertreter: Hörschler, Wolfram Johannes

(56) Entgegenhaltungen:
- CH-A5- 690 354
- DE-A1- 2 916 839
- DE-A1- 3 741 652
- DE-A1- 10 334 792
- DE-A1- 19 707 287
- DE-A1- 19 813 924
- DE-A1-102004 003 797
- DE-A1-102005 012 114
- DE-C2- 19 622 882
- GB-A- 1 406 110
- US-A- 3 598 131

## Beschreibung

### Gebiet der Erfindung

Die Erfindung betrifft ein Reinigungsgerät zur Reinigung von Reinigungsgut in einer Reinigungskammer, wobei das Reinigungsgerät eine Wärmerückgewinnungseinrichtung aufweist. Weiterhin betrifft die Erfindung ein Verfahren zur Wärmerückgewinnung in einem Reinigungsgerät. Derartige Reinigungsgeräte und Verfahren zur Wärmerückgewinnung werden beispielsweise in Großküchen zur Reinigung von Geschirr, Gläsern, Tassen, Besteck, Tabletts oder ähnlichem Reinigungsgut eingesetzt. Auch andere Anwendungsgebiete und Arten von Reinigungsgut, insbesondere im gewerblichen Bereich, sind jedoch denkbar.

### Stand der Technik

Aus den verschiedensten Bereichen der Technik und Naturwissenschaften sind Reinigungsgeräte bekannt, mittels derer verschiedene Arten von Reinigungsgut mit unterschiedlichen Zielsetzungen gereinigt werden können. Eine Zielsetzung ist beispielsweise die zumindest weitgehende Befreiung des Reinigungsgutes von anhaftenden Schmutzresten, eine andere Zielsetzung, welche alternativ oder zusätzlich realisiert werden kann, die Hygienisierung des Reinigungsgutes, welche bis hin zu einer Desinfektion des Reinigungsgutes reichen kann. Die Reinigung erfolgt in der Regel durch Beaufschlagung des Reinigungsgutes mit mindestens einem Reinigungsfluid, welches beispielsweise ein flüssiges Reinigungsfluid (zum Beispiel eine oder mehrere Spülflüssigkeiten, beispielsweise mit einem Reinigungsmittel und/oder einem Klarspüler versetztes Wasser) und/oder ein gasförmiges Reinigungsfluid, wie beispielsweise Dampf, umfassen kann.

In vielen Fällen muss in einem derartigen Reinigungsgerät eine nicht unerhebliche Menge an thermischer Energie aufgebracht werden. Diese thermische Energie kann unmittelbar beim Reinigungsprozess benötigt werden, beispielsweise indem das Reinigungsfluid mit einer erhöhten Temperatur auf das Reinigungsgut aufgebracht wird. Beispielsweise können für einen Klarspülvorgang in einer Geschirrspülmaschine Klarspülflüssigkeiten mit einer Temperatur von ca. 85 °C eingesetzt werden. Ein weiteres Beispiel ist die thermische Energie, welche zur Erzeugung des Dampfes in Dampfsterilisatoren und/oder Dampfdesinfektionsgeräten erforderlich ist. Weiterhin können Reinigungsgeräte auch derart eingerichtet sein, dass ein oder mehrere Trocknungsschritte durchgeführt werden. Bei einer derartigen Trocknung kann beispielsweise das Reinigungsgut mit warmer Luft beaufschlagt werden, wofür ebenfalls thermische Energie aufgewendet werden muss.

Insbesondere im gewerblichen Bereich kann dieser thermische Energieaufwand eine erhebliche Größenordnung annehmen, so dass beispielsweise Heizleistungen einen beträchtlichen Beitrag zu den gesamten Betriebskosten des Reinigungsgerätes bilden können. In gewerblichen Geschirrspülmaschinen betragen die Heizleistungen beispielsweise von einigen 10 kW bis hin zu einigen 100 kW, abhängig beispielsweise vom Betriebszustand und/oder der Ausgestaltung der Geschirrspülmaschine.

Eine weitere Problematik bei bekannten Reinigungsgeräten, insbesondere im Bereich der gewerblichen Nutzung, besteht darin, dass diese in der Regel in einer Arbeitsumgebung eingesetzt werden, welche durch Abwärme des Reinigungsgerätes, insbesondere durch feuchte Abwärme, nicht über Gebühr belastet werden sollte. So ist beispielsweise in Großküchen ein erheblicher Aufwand erforderlich, um feuchte Abwärme, welche in den Geschirrspülmaschinen gebildet wird, nicht unmittelbar in die Arbeitsumgebung zu leiten, da ansonsten die Arbeitsbedingungen in dieser Arbeitsumgebung innerhalb kurzer Zeit unzumutbar würden. Insofern sind beispielsweise aufwändige bauseitige Abluftvorrichtungen erforderlich, um die feuchte Abwärme aus der Arbeitsumgebung abzuleiten. Alternativ oder zusätzlich können die Reinigungsgeräte Trocknungsvorrichtungen aufweisen, um der Abluft Feuchtigkeit zu entziehen und/oder um die Abluft zu kühlen.

Zahlreiche Trocknungsvorrichtungen, welche die Trocknung des Reinigungsgutes unterstützen und somit grundsätzlich auch die in die Umgebung abgegebene Abluft entfeuchten, sind aus dem Stand der Technik bekannt. Ein aus dem Stand der Technik bekanntes Trocknungskonzept besteht darin, Reinigungsgeräte mit so genannten Latentwärmespeichern auszustatten. Latentwärmespeicher sind Einrichtungen, welche thermische Energie durch Ausnutzung der Enthalpie reversibler thermodynamischer Zustandsänderungen eines Speichermediums (im Folgenden Wärmespeichermaterialien genannt) speichern können. Ein typisches Beispiel für derartige reversible thermodynamische Zustandsänderungen sind beispielsweise Phasenübergänge (z.B. Schmelzen/Erstarren) oder reversible chemische Reaktionen, wie beispielsweise auf Chemiesorption beruhende Absorptions- und Desorptionsprozesse oder Prozesse, bei welchen ein Kristallisationsphasenübergang stattfindet. Ein Beispiel einer Haushaltsgeschirrspülmaschine, in welcher ein thermisch isolierter Wärmetauscher mit einem Latentwärmespeicher eingesetzt wird, ist in DE 37 41 652 A1 beschrieben. Andere Beispiele derartiger Haushaltsgeräte mit ähnlichen Vorrichtungen mit Latentwärmespeichern finden sich in DE 37 00 567 A1 (dort ein Backofen), in DE 10 2005 012 114 A1 (eine Geschirrspülmaschine) oder in DE 196 22 882 C2 (ebenfalls eine Geschirrspülmaschine). In DE 29 16 839 ist allgemein ein Verfahren zur Entnahme von Wärmeenergie aus warmen Flüssigkeiten beschrieben, in welchem mehrere Latentwärmespeicher, die auf verschiedenen Temperaturniveaus betrieben werden, nacheinander von den Flüssigkeiten durchströmt werden.

Ein weiteres Beispiel eines Trocknungsprinzips sind Trocknungsvorrichtungen, welche mit Hilfe von Peltierelementen arbeiten. Ein Beispiel einer derartigen Trocknungsvorrichtung ist aus DE 198 13 924 A1 bekannt. Diese Druckschrift zeigt eine Kondensationseinrichtung für ein Hausgerät, umfassend ein Modulelement mit einem Peltierelement. Das Peltierelement weist eine wärmeaufnehmende Fläche und eine wärmeabgebende Fläche auf. Die wärmeaufnehmende Fläche entzieht einer Arbeitsraumatmosphäre eines Arbeitsraums des Haushaltsgeräts Wärme, wodurch Feuchtigkeit der Arbeitsraumatmosphäre an der gekühlten Stelle kondensiert und so ein Trocknungsvorgang des Haushaltsgeräts wirksamer und schneller ist. Die wärmeabgebende Fläche des Peltierelements kann auch an ein wärmeaufnehmendes Volumen, wie zum Beispiel einen Wasserbehälter, gekoppelt sein.

Nachteilig an der in der DE 198 13 924 A1 beschriebenen Vorrichtung aus der Sicht der gewerblichen Anwendbarkeit ist jedoch, dass der Wasserbehälter zur Kühlung des Peltierelements, falls sich dieser zu stark erwärmt, entleert und mit Frischwasser gefüllt werden muss. Insofern ist zum einen die Funktionalität der Kondensationseinrichtung instabil und kann über eine längere Betriebsdauer schwanken. Insbesondere in gewerblichen Reinigungsgeräten, welche beispielsweise permanent in einem mehrstündigen Betrieb arbeiten müssen, kann dies von erheblichem Nachteil sein. Zudem ist ein sicherer und zuverlässiger Trocknungsbetrieb aufgrund der beschriebenen Temperaturdrift im Wasserbehälter nicht in allen Fällen gewährleistet. Weiterhin geht die in der Abwärme enthaltene Energie verloren, und es muss für den Betrieb des Peltierelements sogar zusätzlich Energie aufgewendet werden.

Auch aus dem Bereich der Klimatechnik sind Kühlgeräte bekannt, in welchen Peltierelemente zum Klimatisieren von Raumluft und anderen Medien eingesetzt werden. So beschreibt beispielsweise EP 0 842 382 B1 ein H-Thermokompaktgerät, welches aus Thermoelementblöcken mit mehreren Peltierelementen besteht. Dabei wird thermische Energie von einem Medium auf einer Kaltseite hin zu einem Medium auf einer Warmseite übertragen. Unter anderem wird dabei vorgeschlagen, das entstandene Warmwasser als Brauchwasser zu sammeln und zur Weiterverwendung zur Verfügung zu stellen. Insgesamt ist der in EP 0 842 382 B1 beschriebene Aufbau jedoch vergleichsweise komplex.

Aus dem Bereich gewerblicher Geschirrspülmaschinen sind Reinigungsgeräte bekannt, welche nicht nur die beschriebene Problematik der Abluftbelastung der Umgebung zu mindern versuchen, sondern welche auch darauf ausgelegt sind, eine zumindest teilweise Wärmerückgewinnung der in der Abwärme enthaltenen thermischen Energie zu ermöglichen. Ein Beispiel derartiger Systeme ist in US 3,598,131 dargestellt. Hierbei wird mittels einer Absaugvorrichtung Dampf aus einer Geschirrspülmaschine in einen Schacht abgesaugt und über einen Wärmetauscher geleitet. Der Wärmetauscher ist in diesem Fall als poröses Material ausgestaltet, welches mit Frischwasser besprüht wird. Die kondensierte Feuchtigkeit wird aufgesammelt und der Geschirrspülmaschine wieder zugeführt. Eine ähnliche Geschirrspülmaschine mit Wärmerückgewinnung ist auch in DE 10 2004 003 797 A1 dargestellt.

Nachteilig an dem in US 3,598,131 dargestellten Reinigungsgerät ist jedoch, dass die Funktionalität der Wärmerückgewinnungseinrichtung stark von der Temperatur des aufgesprühten Kaltwassers abhängt. Wird die Geschirrspülmaschine beispielsweise in Gegenden mit heißem Klima betrieben, so hat üblicherweise das "Kaltwasser" eine andere Temperatur als in Gegenden mit milderem oder sogar kühlem Klima. Insofern kann die Funktionalität der Wärmerückgewinnungseinrichtung stark schwanken, und eine gezielte Entfeuchtung bzw. Kühlung kann nicht in allen Fällen gewährleistet werden.

Ein weiterer Nachteil der in US 3,598,131 gezeigten Wärmerückgewinnungseinrichtung besteht darin, dass Kühlflüssigkeit sich mit dem kondensierten Wasser vermischt, so dass insgesamt das rückgeführte Wasser eine vergleichsweise niedrige Temperatur aufweist und in der Regel nachgeheizt werden muss, bevor dieses dem Reinigungsvorgang wieder zugeführt werden kann. Zudem ist die gezeigte Wärmerückgewinnungseinrichtung aus hygienischen Aspekten nachteilig, da ein Verkeimen des kondensierten Wassers und somit des Reinigungsguts bzw. des porösen Wärmetauschers zu befürchten ist.

Ein weiterer Nachteil bekannter Wärmerückgewinnungseinrichtungen, wie beispielsweise der in US 3,598,131 oder in DE 10 2004 003 797 A1 gezeigten Einrichtungen, besteht darin, dass derartige Vorrichtungen nicht in allen Betriebszuständen einwandfrei arbeiten können. So ist insbesondere in gewerblichen Geschirrspülmaschinen in vielen Fällen ein so genannter Standby-Betrieb vorgesehen, also ein Betrieb, in welchem eine Betriebsbereitschaft des Reinigungsgeräts hergestellt bzw. aufrecht erhalten wird, ohne dass derzeit ein Reinigungsprozess durchgeführt wird. Während dieser Zeit wird üblicherweise mindestens ein Fluidtank für ein Reinigungsfluid aufgeheizt, um die Betriebsbereitschaft herzustellen bzw. zu erhalten. Hierbei entstehen Dampfwrasen, welche, um einen Überdruck zu vermeiden, in der Regel aus dem Reinigungsgerät abgeführt werden müssen. Somit würden bereits im Standby-Betrieb Wrasen und Abwärme entstehen, welche die Umgebungsluft belasten könnten. Die bekannten Wärmerückgewinnungseinrichtungen sind jedoch nur bedingt für die Beseitigung dieser Wrasen geeignet, da im Standby-Betrieb kein Frischwasser fließt, welches die Wärme aufnehmen und dem Reinigungsgerät wieder zuführen könnte. Eine zusätzliche Frischwasseraufnahme würde jedoch die Betriebskosten steigern. Spätestens wenn ein oder mehrere Fluidtanks des Reinigungsgerätes mit erwärmtem Wasser gefüllt sind, hätte die Wärmerückgewinnung im Standby-Betrieb ohnehin ein Ende, da in diesem Fall das erwärmte Wasser in einen Ablauf entsorgt werden müsste, was wiederum die rückgewonnene Energie verschwenden würde.

Weiterhin besteht theoretisch die Möglichkeit, zur Wärmerückgewinnung so genannte Wärmepumpen einzusetzen. Wärmepumpen sind Maschinen, die unter Zufuhr von mechanischer Arbeit Wärme von einem niedrigen zu einem höheren Temperaturniveau pumpen. Auf diese Weise kann insbesondere der Problematik begegnet werden, dass Kühlwasser nach Durchströmen der Wärmerückgewinnungseinrichtung eine vergleichsweise niedrige Temperatur hat und nach einer Rückführung in das Reinigungsgerät weiter aufgeheizt werden muss. Bei Wärmepumpen wird in der Regel eine Verdampfungswärme genutzt, um beispielsweise der Abwärme einer Geschirrspülmaschine eine Wärmemenge zu entziehen. Wärmepumpen lassen sich jedoch in der Regel nicht bedarfsweise regeln und weisen in der Praxis Restriktionen im Regelverhalten auf, da lediglich eine Zweipunktregelung möglich ist. Zudem weisen diese einen definierten Betriebspunkt mit festgelegter Toleranz auf, welcher nicht skalierbar ist. Dies ist insbesondere für den gewerblichen Einsatz in vielen Fällen problematisch. Zudem sind mit dem Einsatz von Wärmepumpen zumeist beträchtliche zusätzliche Kosten sowie die Einplanung erheblicher Bauräume verbunden. Weitere Nachteile der Verwendung von Wärmepumpen liegen in dem im Betrieb entstehenden Lärm, dem hohen mechanischen Verschleiß und in Vibrationen. Ein andere Reinigungsgerät gemäß dem Oberbegriff des Einspruchs Δ ist aus DE Δ9707187 C2 bekannt.

### Aufgabe der vorliegenden Erfindung

Eine Aufgabe der vorliegenden Erfindung besteht somit darin, ein Reinigungsgerät sowie ein Verfahren zum Betrieb eines derartigen Reinigungsgerätes bereitzustellen, welche die oben beschriebenen Nachteile bekannter Reinigungsgeräte und/oder Verfahren vermeiden.

Insbesondere soll eine Wärmerückgewinnung bereitgestellt werden, welche stabil und zuverlässig unter verschiedenen Betriebsbedingungen betreibbar ist, welche flexibel einsetzbar ist und welche eine effiziente Rückführung von Wärme ermöglicht. Insbesondere soll die Wärmerückgewinnung auch in einem Standby-Betrieb durchführbar sein.

### Beschreibung der Erfindung

Diese Aufgabe wird durch ein Reinigungsgerät sowie ein Verfahren zur Wärmerückgewinnung in einem Reinigungsgerät gemäß den unabhängigen Ansprüchen gelöst. Vorteilhafte Weiterbildungen der Erfindung, welche einzeln oder in Kombination realisiert werden können, sind in den abhängigen Ansprüchen dargestellt. Sämtliche Ansprüche werden hiermit durch Bezugnahme zum Inhalt dieser Beschreibung gemacht.

Es wird ein Reinigungsgerät zur Reinigung von Reinigungsgut vorgeschlagen, welches eingerichtet ist, um das Reinigungsgut in mindestens einer Reinigungskammer mit mindestens einem Reinigungsfluid zu beaufschlagen. Die Reinigungskammer kann geschlossen (beispielsweise mit einem Öffnungsmechanismus zum Be- und Entladen mit Reinigungsgut) und/oder teilweise offen (z.B. mit einer oder mehreren Beladeöffnungen versehen) ausgestaltet sein und soll sicherstellen, dass Reinigungsfluid nicht ungehindert in die Arbeitsumgebung spritzen kann und dass beispielsweise Dampfwrasen nicht oder nur in vermindertem Umfang aus dem Reinigungsgerät ausströmen können. Das Reinigungsgerät kann beispielsweise grundsätzlich gemäß einem der eingangs beschriebenen Reinigungsgeräte ausgestaltet sein. Beispielsweise kann das Reinigungsgerät eine Geschirrspülmaschine, insbesondere eine gewerbliche Geschirrspülmaschine aufweisen, wobei jedoch auch nichtgewerbliche Geschirrspülmaschinen möglich sind. Gewerbliche Geschirrspülmaschinen unterscheiden sich in der Regel von Haushaltsgeräten dadurch, dass, um schneller ein Reinigungsfluid mit einer benötigten Reinigungstemperatur bereitzustellen zu können, ein separater, das heißt von der Reinigungskammer getrennter Fluidtank (insbesondere ein Boiler und/oder ein Durchlauferhitzer) vorgesehen ist, wohingegen in Haushaltsgeräten üblicherweise ein Wasserwechsel innerhalb der Reinigungskammer erfolgt. Die Geschirrspülmaschine kann beispielsweise eine Durchlaufgeschirrspülmaschine, insbesondere eine Bandtransportmaschine und/oder eine Korbtransportmaschine, umfassen. Alternativ oder zusätzlich kann auch eine Einkammer-Geschirrspülmaschine, insbesondere wiederum für den gewerblichen Einsatz, umfasst sein, beispielsweise eine Einkammer-Geschirrspülmaschine in Form eines Frontladers und/oder eine Einkammer-Geschirrspülmaschine in Form eines Topladers und/oder einer Haubengeschirrspülmaschine. Alternativ oder zusätzlich zu mindestens einer Geschirrspülmaschine kann das Reinigungsgerät jedoch auch eine andere Art von Reinigungsgerät zur Reinigung von Reinigungsgut beinhalten, beispielsweise ein Dampfdesinfektionsgerät und/oder einen Dampfsterilisator, beispielsweise zur Reinigung von in Krankenhäusern und/oder Pflegeheimen anfallendem medizinischem Reinigungsgut. Auch andere Arten von Reinigungsgeräten sind jedoch möglich. Neben den genannten Geräten kann das Reinigungsgerät weitere Einrichtungen umfassen, so dass beispielsweise mehrere Geschirrspülmaschinen zu einer Spülstraße zusammengefasst sind, welche auch noch zusätzliche, in Großküchen benötigte Geräte umfassen kann.

Das Reinigungsgerät umfasst vorzugsweise mindestens einen Fluidtank zur Bevorratung des Reinigungsfluids, aus welchem dann beispielsweise eine oder mehrere Sprühdüsen mit Reinigungsfluid gespeist werden können. Dieser Fluidtank kann getrennt von der Reinigungskammer ausgebildet sein und/oder kann auch als Bestandteil der Reinigungskammer konstruiert werden. Der Fluidtank kann weiterhin ganz oder teilweise als Drucktank ausgestaltet sein, kann jedoch auch ganz oder teilweise als druckloser Tank gestaltet werden. Die Ausgestaltung des mindestens einen Fluidtanks kann an die Art des Reinigungsgerätes angepasst sein. Wird beispielsweise eine Durchlaufgeschirrspülmaschine mit einer oder mehreren Reinigungszonen verwendet, so kann beispielsweise jeder Reinigungszone und/oder mehreren Reinigungszonen gemeinsam ein derartiger Fluidtank zugeordnet sein. Besonders bevorzugt ist es dabei, wenn die Durchlaufgeschirrspülmaschine derart eingerichtet ist, dass Reinigungsgut die mindestens eine Reinigungszone in einer Durchlaufrichtung durchläuft. Beispielsweise kann die mindestens eine Reinigungszone mindestens eine Pumpenklarspülzone und/oder mindestens eine Frischwasserklarspülzone umfassen, welche mindestens einen Klarspültank aufweist, wobei der mindestens eine Fluidtank in diesem Fall beispielsweise den mindestens einen Klarspültank umfassen kann.

Der Begriff "Fluidtank" ist jedoch weit zu fassen und kann, muss aber nicht notwendigerweise, einen Container mit erweitertem Durchmesser zur Bevorratung einer Menge an Reinigungsfluid umfassen. Der Fluidtank kann auch ganz oder teilweise in die Reinigungskammer integriert sein, beispielsweise indem der Fluidtank in einem Bodenbereich der Reinigungskammer ausgebildet ist. Alternativ oder zusätzlich kann der mindestens eine Fluidtank jedoch auch einen separaten Tank umfassen. Es können auch mehrere Fluidtanks vorgesehen sein, beispielsweise für unterschiedliche Teilprozesses der Reinigung. Sind mehrere Reinigungszonen vorgesehen, so kann beispielsweise jeder Reinigungszone mindestens ein Fluidtank zugeordnet sein, wobei einer oder mehrere dieser Fluidtanks für die unten beschriebene Wärmerückführung genutzt werden können. Der mindestens eine Fluidtank kann weiterhin ein oder mehrere druckbeaufschlagte und/oder drucklose Reservoire zur Bevorratung einer Menge an über ein Rohrleitungssystem zugeführtem Reinigungsfluid umfassen, kann jedoch auch ganz oder teilweise lediglich als durchströmtes Rohrleitungssystem ausgestaltet sein, in welchem das Reinigungsfluid strömen kann. So kann beispielsweise das erwärmte erste Kühlfluid nach Durchströmen einer Wärmerückgewinnungseinrichtung (siehe unten) auch unmittelbar der Frischwasserklarspülzone zugeführt werden, wobei in diesem Fall das Rohrleitungssystem zwischen Wärmerückgewinnungseinrichtung und Frischwasserklarspülzone als "Fluidtank" im weiteren Sinne verstanden werden kann. Dieses Rohrleitungssystem kann beispielsweise auch mit zusätzlichen Durchlauferhitzern ausgestattet sein, um das erste Kühlfluid weiter zu erwärmen. Maßgeblich ist in jedem Fall jedoch, dass das in der Wärmerückgewinnungseinrichtung erwärmte erste Kühlfluid dem Reinigungsprozess in irgendeiner Form wieder zugeführt wird, um die in diesem ersten Kühlfluid gespeicherte Wärme wieder nutzen zu können.

Wie oben beschrieben, kann das Reinigungsfluid beispielsweise mindestens ein flüssiges und/oder mindestens ein gasförmiges Reinigungsfluid umfassen. In der folgenden Beschreibung sei ohne Beschränkung des Umfangs der Erfindung davon ausgegangen, dass das Reinigungsfluid ein wässriges Reinigungsfluid ist, wie es beispielsweise in Geschirrspülmaschinen eingesetzt wird. Diesem wässrigen Reinigungsfluid können beispielsweise ein Reinigungsmittel und/oder ein Klarspüler beigemischt sein. Auch andere Arten der Beimischungen und/oder Zusammensetzungen des Reinigungsfluids sind jedoch denkbar und im Rahmen der vorliegenden Erfindung realisierbar. Insbesondere kann das Reinigungsfluid mit einer gegenüber der Raumtemperatur erhöhten Temperatur betrieben werden, beispielsweise Temperaturen im Bereich von 60 °C und/oder Temperaturen im Bereich von 80 bis 90 °C, beispielsweise 85 °C. Letzteres wird insbesondere im Bereich der Klarspülung favorisiert. Andere Arten der Temperaturgestaltung sind jedoch ebenfalls denkbar.

Zur Minderung der oben beschriebenen Problematik der Belastung der Arbeitsumgebung des Reinigungsgeräts mit feuchter Luft, insbesondere mit Dampfwrasen, weist das Reinigungsgerät eine Absaugvorrichtung zum Absaugen von feuchter Luft aus der Reinigungskammer auf. Diese Absaugvorrichtung kann beispielsweise eine Abluftöffnung aufweisen, durch welche die feuchte Luft (beispielsweise nach Durchtritt durch die unten beschriebene Wärmerückgewinnungseinrichtung) aus dem Reinigungsgerät ausgeleitet wird. Diese Abluftöffnung kann beispielsweise unmittelbar und/oder über einen Filter in die Arbeitsumgebung des Reinigungsgerätes münden. Alternativ oder zusätzlich kann die mindestens eine Abluftvorrichtung jedoch auch an eine bauseitig vorgesehene Ablufteinrichtung, beispielsweise ein Entlüftungsrohr, angeschlossen werden.

Die Begriffe der "Absaugvorrichtung" und des "Absaugens" sind wiederum weit zu fassen und können beispielsweise eine aktive Absaugung (beispielsweise mittels eines oder mehrerer Absauggebläse) der feuchten Luft beinhalten. Alternativ kann die Absaugvorrichtung jedoch auch ohne Gebläse ausgestaltet sein und beispielsweise lediglich die mindestens eine Abluftöffnung umfassen. In diesem Fall kann für den Zweck der Absaugung dann beispielsweise ein an der Ablufteinrichtung bauseitig anliegender Unterdruck verwendet werden, oder, alternativ oder zusätzlich, ein Überdruck der feuchten Luft gegenüber der Umgebungsluft oder besondere Luftströmungen, welche den Austrag feuchter Luft aus dem Reinigungsgerät begünstigen, oder einfach eine Konvektion der feuchten Luft. Die Absaugung und die Absaugvorrichtung sollen sich also lediglich dadurch definieren, dass diese einen Austrag der feuchten Luft aus dem Reinigungsgerät in irgendeiner Weise ermöglichen und/oder begünstigen.

Das Reinigungsgerät weist weiterhin mindestens eine Wärmerückgewinnungseinrichtung auf. Diese Wärmerückgewinnungseinrichtung ist eingerichtet, um der feuchten Luft Wärme zu entziehen und diese Wärme dem Reinigungsgerät bzw. einem gleichzeitigen oder sich zeitlich anschließenden Reinigungsprozess über ein erstes Kühlfluid wieder zuzuführen.

Im Unterschied zu bekannten Wärmerückgewinnungseinrichtungen, wie beispielsweise der in US 3,598,131 beschriebenen Wärmerückgewinnungseinrichtung oder der in DE 10 2004 003 797 A1 beschriebenen Wärmerückgewinnungseinrichtung, besteht ein Grundgedanke der vorliegenden Erfindung jedoch darin, das Reinigungsgerät derart auszugestalten, dass ein Latentwärmespeicher vorgesehen wird. Im Unterschied zu bekannten Reinigungsgeräten mit Latentwärmespeichern, wie beispielsweise den aus DE 10 2005 012 114 A1 oder DE 37 41 652 A1 bekannten Reinigungsgeräten, wird der Latentwärmespeicher jedoch nicht permanent zur Wärmerückgewinnung bzw. Dampfkondensation eingesetzt, sondern nur bedarfsweise zu- oder abgeschaltet. Dieser Grundgedanke dient insbesondere dem Zweck, der oben beschriebenen Problematik der Wrasenbeseitigung im Standby-Betrieb zu begegnen. Dementsprechend weist das Reinigungsgerät eine Kühlfluidleitung mit mindestens einem Rückführpfad sowie mindestens einem Wärmespeicherpfad auf, wobei der mindestens eine Wärmespeicherpfad mindestens einen Latentwärmespeicher umfasst. Das Reinigungsgerät ist eingerichtet, um das erste Kühlfluid in mindestens einem Betriebszustand nach Durchströmen der Wärmerückgewinnungseinrichtung über den Rückführpfad zu der Reinigungskammer und/oder in den Fluidtank zu leiten. Unter einem "Betriebszustand" ist dabei beispielsweise mindestens ein Reinigungsbetrieb zu verstehen, also ein Zustand, in welchem das Reinigungsgut mit Reinigungsfluid beaufschlagt wird. Weiterhin ist das Reinigungsgerät jedoch eingerichtet, um in mindestens einem Standby-Betrieb das erste Kühlfluid über den Wärmespeicherpfad dem Latentwärmespeicher zuzuführen. Die Wärmerückgewinnung "unterscheidet" somit zwischen dem Betriebszustand (Normalbetrieb, Reinigungsbetrieb) und dem Standby-Betrieb, in welchem keine Beaufschlagung des Reinigungsgutes mit Reinigungsfluid erfolgt.

Der mindestens eine Betriebszustand definiert sich somit daraus, dass in diesem das Reinigungsgut mit mindestens einem Reinigungsfluid beaufschlagt wird. Beispielsweise kann der Betriebszustand ein Vorspülen, ein Hauptspülen, ein Klarspülen oder eine Kombination derartiger Spülvorgänge umfassen. Der mindestens eine Standby-Betrieb definiert sich dementsprechend daraus, dass in diesem Zustand keine Beaufschlagung des Reinigungsgutes mit dem Reinigungsfluid erfolgt, oder dass eine Beaufschlagung des Reinigungsgutes mit einer anderen Art von Reinigungsfluid (beispielsweise Dampf) erfolgt, so dass in diesem Standby-Betrieb in der Regel kein Reinigungsfluid benötigt wird. Das Reinigungsgerät kann somit derart eingerichtet sein (beispielsweise durch Verwendung einer zentralen Steuereinheit), dass zwischen diesen Betriebszuständen und/oder Standby-Betrieben umgeschaltet werden kann. Dieses Umschalten kann physikalisch mit einer Umlenkung des Flusses des ersten Kühlfluids zwischen Rückführpfad und Wärmespeicherpfad erfolgen, wobei zusätzlich auch Heizungen und/oder Pumpenmotoren ausgeschaltet werden können. Für diese Umlenkung oder Umschaltung zwischen den genannten Pfaden können beispielsweise ein oder mehrere Ventile, beispielsweise Magnetventile, vorgesehen sein.

Gegenüber herkömmlichen Reinigungsgeräten bietet das vorgeschlagene Reinigungsgerät somit den Vorteil, dass auch in einem Standby-Betrieb, in welchem kein Reinigungsfluid benötigt wird, eine effiziente Wärmerückgewinnung, verbunden mit einer Dampfwrasenbeseitigung, erfolgen kann.

Die rückgewonnene Wärme kann auf effiziente Weise in dem Latentwärmespeicher zwischengespeichert werden, um diese dann anschließend, beispielsweise nach Beendigung des Standby-Betriebs und/oder nach Beginn des Betriebszustands (das heißt des mindestens einen Reinigungsbetriebs), zumindest teilweise wieder dem Reinigungsprozess zuzuführen. Hierfür kann unter Zuhilfenahme eines Fluids, insbesondere des ersten Kühlfluids, diese Wärme zumindest teilweise wieder zu der Reinigungskammer und/oder in den Fluidtank überführt werden. Zu diesem Zweck kann beispielsweise das erste Kühlfluid nach Beginn des Betriebszustands noch kurzfristig durch den Wärmespeicherpfad und/oder durch einen den Latentwärmespeicher umfassenden Übergangspfad geleitet werden, beispielsweise während einer Übergangsphase, um die im Latentwärmespeicher gespeicherte Wärme in den Fluidtank zu überführen und/oder auf andere Weise einem Reinigungsprozess im Reinigungsgerät zuzuführen. Alternativ oder zusätzlich ist auch eine andere Art der Überführung der gespeicherten Wärme aus dem Latentwärmespeicher nach Beendigung des Standby-Betriebes in den Fluidtank und/oder in die Reinigungskammer möglich, beispielsweise mittels eines von dem ersten Kühlfluid verschiedenen Transferfluids. Anschließend an die Übergangsphase kann das erste Reinigungsfluid dann wieder über den Rückführpfad geleitet werden.

Unter einem "Kühlfluid" ist dabei hier wie im Folgenden beispielsweise wiederum ein flüssiges und/oder gasförmiges Medium zu verstehen, welches beispielsweise analog zum oben beschriebenen Reinigungsfluid ausgestaltet sein kann. Da das erste Kühlfluid in diesem Fall tatsächlich auch in einem nachfolgenden Schritt als Reinigungsfluid verwendet werden kann, kann das erste Kühlfluid beispielsweise wiederum ein wässriges Kühlfluid umfassen, beispielsweise Frischwasser mit einer Beimengung von Reinigungsmitteln und/oder Klarspüler.

Der Latentwärmespeicher kann grundsätzlich ausgestaltet sein wie die aus dem oben genannten Stand der Technik bekannten Latentwärmespeicher und kann insbesondere mindestens ein Wärmespeichermaterial umfassen, welches eine Übergangstemperatur (das heißt eine Umwandlungstemperatur bzw. einen Umwandlungstemperaturbereich) in einem geeigneten Temperaturbereich aufweist. Unter einem "geeigneten" Temperaturbereich ist dabei ein Temperaturbereich, welcher einerseits oberhalb der Raumtemperatur liegt (damit bei Raumtemperatur die Umwandlung zumindest noch nicht vollständig stattgefunden hat) und welcher andererseits in etwa in dem Temperaturbereich liegt, in welchem die feuchte Luft in der Wärmerückgewinnungseinrichtung auftritt, insbesondere im Standby-Betrieb. Als besonders geeignet hat sich dabei ein Temperaturbereich für die mindestens eine Übergangstemperatur erwiesen, welcher sich zwischen 30 °C und 90 °C, insbesondere im Bereich zwischen 50 °C und 80 °C und besonders bevorzugt bei ca. 70 °C befindet. Insbesondere kann der Latentwärmespeicher auch als mehrstufiger Latentwärmespeicher mit mindestens zwei Übergangstemperaturen ausgestaltet sein, beispielsweise indem mehrere Wärmespeichermaterialien vorgesehen sind. Dabei kann beispielsweise eine Durchströmung des Latentwärmespeichers durch das erste Kühlfluid derart erfolgen, dass zunächst Wärmespeichermaterialien mit höheren Übergangstemperaturen durchströmt werden, und anschließend Wärmespeichermaterialien mit niedrigeren Übergangstemperaturen. Für eine mögliche Ausgestaltung dieser Art kann beispielsweise auf die DE 29 16 839 A1 verwiesen werden.

Dementsprechend lassen sich eine Vielzahl von Wärmespeichermaterialien und/oder Kombinationen dieser Wärmespeichermaterialien einsetzen. Besonders bevorzugt weist der Latentwärmespeicher mindestens eines der folgenden Wärmespeichermaterialien auf: ein Salz; ein Paraffin; Natriumacetat-Trihydrat; Acetamid; t-Crotonsäure; Tristearin; Kaliumaluminiumsulfat, insbesondere in Hydratform; Natriumaluminiumsulfat, insbesondere in Hydratform; Magnesiumnitrat, insbesondere in Hydratform.

Zwar könnte grundsätzlich in dem Standby-Betrieb ein offener Wärmespeicherpfad verwendet werden, um rückgewonnene Wärme aus der Wärmerückgewinnungseinrichtung zu dem Latentwärmespeicher zu überführen. Diese Ausgestaltung wäre jedoch mit dem Nachteil verbunden, dass hierbei stetig das erste Kühlfluid verbraucht würde, so dass beispielsweise, bei Verwendung von Frischwasser, ein Frischwasserverbrauch entstünde. Daher ist es grundsätzlich bevorzugt, wenn der Wärmespeicherpfad als geschlossener Kreislauf ausgestaltet ist, in welchem im Standby-Betrieb das erste Kühlfluid zwischen der Wärmerückgewinnungseinrichtung und dem Latentwärmespeicher zirkulieren kann. Das erste Kühlfluid wird somit im Kreislauf stets in der Wärmerückgewinnungseinrichtung aufgewärmt, wird zum Latentwärmespeicher befördert, gibt dort die aufgenommene Wärme ganz oder teilweise an den Latentwärmespeicher ab, wird dabei abgekühlt und wird schließlich zur Wärmerückgewinnungseinrichtung zurücktransportiert. Dieser Kreislauf kann auch dadurch unterstützt werden, dass der Wärmespeicherpfad zusätzlich eine Pumpe zur Förderung des ersten Kühlfluids aufweist. Auf diese Weise kann ein Verbrauch an erstem Kühlfluid zuverlässig auch im Standby-Betrieb vermieden werden, so dass nicht nur Wärme im Standby-Betrieb rückgewonnen werden kann, sondern dass auch der Kühlfluidverbrauch auf ein Minimum gesenkt werden kann. Das vorgeschlagene Reinigungsgerät zeichnet sich somit gegenüber herkömmlichen Reinigungsgeräten mit Wärmerückgewinnungseinrichtung durch eine hohe Umweltverträglichkeit und geringe Betriebskosten aus.

Weitere vorteilhafte Ausgestaltungen der Erfindung betreffen die Wärmerückgewinnungseinrichtung als solche. Grundsätzlich kann unmittelbar, beispielsweise in einem Fluidwärmetauscher, Abwärme aus der feuchten Luft auf das erste Kühlfluid übertragen werden, welches dann als Trägermedium genutzt wird, um die rückgewonnene Wärme entweder dem Latentwärmespeicher (Standby-Betrieb) und/oder dem Reinigungsprozess (Betriebszustand) wieder zuzuführen. Diese einfache Ausgestaltung der Wärmeübertragung ist jedoch mit dem bereits oben beschriebenen Nachteil verbunden, dass die Effizienz der Wärmerückgewinnung in diesem Fall von der Ausgangstemperatur des ersten Kühlfluids abhängt. Zudem ist eine derartige Wärmeübertragung vergleichsweise ineffizient. In einer bevorzugten Ausgestaltung der Wärmerückgewinnungseinrichtung umfasst diese daher eine Wärmepumpe, insbesondere eine thermomechanische und/oder eine thermoelektrische Wärmepumpe. Eine derartige Wärmepumpe ist ausgestaltet, um unter Zufuhr von mechanischer und/oder elektrischer Arbeit Wärme von einem niedrigerem zu einem höheren Temperaturniveau zu pumpen. Bei einer thermomechanischen Wärmepumpe kann beispielsweise die auf dem hohen Temperaturniveau anfallende Verflüssigungswärme zum Heizen beispielsweise des ersten Kühlfluids genutzt werden.

Dabei ist es besonders bevorzugt, thermoelektrische Wärmepumpen einzusetzen, welche mindestens ein Peltierelement umfassen. Die Wärmerückgewinnungseinrichtung kann dementsprechend mindestens ein Peltierelement mit einer Wärmeaufnahmeseite und einer Abwärmeseite aufweisen. Die Wärmeaufnahmeseite kann direkt oder indirekt genutzt werden, um der feuchten Luft Wärme zu entziehen. Im Unterschied zu bekannten Peltiertrocknern, wie beispielsweise dem aus DE 198 13 924 A1 bekannten Peltiertrockner mit Kopplung der Abwärmeseite mit einem einfachen Wasservolumen, ist jedoch erfindungsgemäß vorzugsweise eine Fluidheizvorrichtung vorgesehen, welche mit der Abwärmeseite in thermischem Kontakt steht. Diese Fluidheizvorrichtung ist vorzugsweise derart eingerichtet, dass diese von einem ersten Kühlfluid durchströmt wird, welches dabei Abwärme von der Abwärmeseite des Peltierelements aufnimmt. Diese Abwärme wird, im Unterschied zur DE 198 13 924 A1, dem Reinigungsgerät wieder zugeführt, indem das erste Kühlfluid nach Durchströmen der Fluidheizvorrichtung zu der Reinigungskammer und/oder in den Fluidtank geleitet wird und so für den Reinigungsvorgang verwendbar ist. Das Reinigungsgerät ist also derart ausgestaltet, dass das erste Kühlfluid nach Durchströmen der Fluidheizvorrichtung, und somit auch die von diesem ersten Kühlfluid aufgenommene Wärme, für einen Reinigungsvorgang in der Reinigungskammer einsetzbar sind.

Der Begriff "durchströmen" ist dabei weit zu fassen. Prinzipiell umfasst dieser Begriff jegliche Art des Transports eines Kühlfluids, hier des ersten Kühlfluids, bei welchem dieses in thermischen Kontakt mit einem "durchströmten Element", hier der Fluidheizvorrichtung, gerät. Neben einem physikalischen Hindurchströmen ist somit also auch ein "Überströmen" und/oder "Entlangströmen" bzw. eine Strömung umfasst, bei welcher das erste Kühlfluid über eine oder mehrere Oberflächen, welche direkt oder indirekt der Fluidheizvorrichtung zugeordnet sind und einen Wärmeübertrag ermöglichen, entlangströmt. Auch komplexere, beispielsweise indirekte, Wärmeübertragungsmechanismen können genutzt werden und sollen vom Begriff "durchströmen" umfasst sein.

Das vorgeschlagene Reinigungsgerät vereinigt somit die Vorteile bekannter Reinigungsgeräte mit Wärmerückgewinnungseinrichtung mit den Vorteilen der bekannten Peltiertrockner, wobei die Nachteile beider Systeme geschickt vermieden werden können. Die vergleichsweise geringen Wirkungsgrade der Peltierelemente werden dabei sogar indirekt vorteilhaft genutzt, da die entstehende Abwärme zumindest teilweise wiedergewonnen werden kann und dem Reinigungsgerät erneut zugeführt werden kann. Im Gegensatz zu Wärmerückgewinnungseinrichtungen mit reinen Flüssigwärmetauschern ist die Aufheizung des ersten Kühlfluids nach Durchströmen der Fluidheizvorrichtung nicht einfach durch Temperaturdifferenzen vorgegeben, sondern kann beispielsweise durch eine entsprechende Ansteuerung des Peltierelements eingestellt werden. Insofern kann eine weitgehende Unabhängigkeit von beispielsweise Eingangstemperaturen des ersten Kühlfluids, wofür beispielsweise Frischwasser in Form von Kaltwasser verwendet werden kann, hergestellt werden. Insofern kann das Reinigungsgerät beispielsweise unter unterschiedlichen klimatischen Bedingungen betrieben werden, ohne dass die Funktionalität der Wärmerückgewinnungseinrichtung beeinträchtigt wird. In der Wärmerückgewinnungseinrichtung kann, gleichzeitig zu einer Abkühlung der feuchten Luft, auch eine zumindest weitgehende und zuverlässige Entfeuchtung stattfinden, so dass beispielsweise durch die Abluftöffnung Abluft an die Umgebung abgegeben werden kann, welche hinsichtlich Temperatur und/oder Feuchtigkeit vorgegebenen Grenzwerten entspricht. Da durch Peltierelemente eine effiziente Kühlung der feuchten Luft gewährleistet werden kann, kann das Reinigungsgerät insofern sogar zur Raumklimatisierung beitragen.

Unter einem "Peltierelement" ist dabei im Rahmen der vorliegenden Erfindung eine thermoelektrische Wärmepumpe bzw. ein elektrothermischer Wandler zu verstehen, welche bzw. welcher auf dem so genannten Peltier-Effekt beruht. Beispielsweise kann ein derartiges Peltierelement zwei oder mehr Halbleiter umfassen, die ein unterschiedliches Energieniveau hinsichtlich ihrer Leitungsbänder aufweisen. Wird ein elektrischer Strom durch zwei hintereinander liegende Kontaktstellen dieser Materialien geleitet, so wird an der einen Kontaktstelle Energie aufgenommen, damit Elektronen in das energetisch höher angeordnete Leitungsband des benachbarten Halbleitermaterials gelangen können. Es kommt hier somit zu einer Abkühlung. An der anderen Kontaktstelle bewegen sich Elektronen von einem höheren auf niedrigere Energieniveaus, so dass hier Energie in Form von Wärme abgegeben wird. Beispielsweise durch Einstellen des elektrischen Stromes kann eine Kühlleistung des Peltierelementes gesteuert werden, wobei übliche Peltierelemente typischerweise eine vorgegebene maximale Temperaturdifferenz zwischen beiden Seiten (Wärmeaufnahmeseite und Abwärmeseite) aufweisen. Beispielsweise kann, je nach Element und Strom, bei einstufigen Peltierelementen die Temperaturdifferenz bis ca. 60-70 Kelvin betragen. Erfindungsgemäß wird die an der Abwärmeseite auftretende Abwärme zumindest teilweise genutzt, so dass zum einen die in DE 198 13 924 A1 beschriebene Wasserwechselproblematik des wärmeaufnehmenden Volumens vermieden werden kann und dass zum anderen diese Abwärme sogar wieder genutzt werden kann.

Neben derartigen "klassischen", auf dem Peltier-Effekt beruhenden thermoelektrischen Elementen umfasst der Begriff des Peltierelements im Rahmen der vorliegenden Erfindung jedoch auch andere Arten thermoelektrischer Elemente, wie beispielsweise so genannte thermionische Konverter. Derartige thermionische Konverter beruhen auf der Erkenntnis, dass in klassischen thermoelektrischen Wandlern eingesetzte Materialien in der Regel nicht nur gute elektrische Eigenschaften aufweisen, sondern auch eine vergleichsweise hohe Wärmeleitfähigkeit. Diese Wärmeleitfähigkeit führt jedoch dazu, dass ein großer Teil der transportierten Wärme wieder zurückfließt zur eigentlich kalten Seite. Es stellt sich ein Gleichgewicht ein, welches den Wirkungsgrad der klassischen thermoelektrischen Elemente verringert. Thermionische Konverter, welche als Sonderfall thermoelektrischer Wandler anzusehen sind, verbessern den Wirkungsgrad durch Verwendung dünner Tunnelschichten, wie beispielsweise Spalten oder Abstände (gaps), in den Bauelementen, beispielsweise Abständen zwischen 0,2 und 5 Mikrometern. Während Elektronen diese Abstände durch Tunneln überwinden können, wirken diese Abstände als effiziente Barriere für die Wärmeleitung, so dass ein Rücktransport der Wärme erschwert wird. Das Gleichgewicht wird daher zugunsten einer Aufheizung der warmen Seite der Elemente verschoben, so dass insgesamt der Wirkungsgrad der thermoelektrischen Elemente ansteigt. Um das Tunneln der Elektronen zu erleichtern, werden im Bereich der gaps häufig unedle Materialien verwendet, also Materialien mit einer niedrigen Austrittsarbeit. Beispiele derartiger Materialien sind Alkali- und Erdalkalimetalle, oder so genannte Avto-Metalle. Moderne Beispiele derartiger thermionischer Konverter, wie sie im Rahmen der vorliegenden Erfindung einsetzbar sind und ebenfalls unter den Begriff der Peltierelemente fallen, sind die so genannten "Cool Chips" der Fa. Cool Chips plc. in Gibraltar. Es sei darauf hingewiesen, dass das mindestens eine Peltierelement auch mehrere, nach verschieden physikalischen Prinzipien arbeitende Elemente umfassen kann, beispielsweise eine Kombination aus "klassischen" Peltierelementen und Cool Chips.

Das erfindungsgemäße Reinigungsgerät kann weiterhin vorteilhaft dadurch weitergebildet werden, dass die Wärmerückgewinnungseinrichtung mehrstufig aufgebaut wird. Diesem Gedanken liegt die Idee zugrunde, dass Peltierelemente, unabhängig von der Temperatur des zu kühlenden Mediums, das zu kühlende Medium abkühlen können, wobei die Abkühlung beispielsweise lediglich von dem angelegten Strom und/oder der Differenztemperatur zwischen Wärmeaufnahmeseite und Abwärmeseite abhängt. Im Gegensatz zu herkömmlichen, in Wärmerückgewinnungseinrichtungen verwendeten Flüssigkeitswärmetauschern, welche lediglich bei einer möglichst hohen Temperatur der feuchten Luft effizient arbeiten können, kann die Peltierkühlung also auch als nachgeschaltete Stufe in einer mehrstufigen Wärmerückgewinnungseinrichtung eingesetzt werden, um bereits teilweise abgekühlter feuchter Luft weiter Wärme zu entziehen.

Dementsprechend kann die Wärmerückgewinnungseinrichtung beispielsweise zusätzliche Wärmetauscher umfassen, welche ganz oder teilweise dem Peltierelement vorgeschaltet sein können. Beispielsweise können hierbei Kühlschlangen, Plattenwärmetauscher und/oder Berieselungswärmetauscher (beispielsweise analog zur US 3,598,131) zum Einsatz kommen. Besonders bevorzugt ist es, wenn die Wärmerückgewinnungseinrichtung mindestens einen ersten Fluidwärmetauscher aufweist, welcher derart eingerichtet ist, dass dieser der feuchten Luft eine erste Wärmemenge entzieht. Die Wärmeaufnahmeseite des Peltierelements ist dementsprechend eingerichtet, um der feuchten Luft eine zweite Wärmemenge zu entziehen. Wie oben beschrieben, ist dies aufgrund der Tatsache möglich, dass die "thermoelektrische Wärmepumpe" des Peltierelements auch bei bereits teilweise abgekühlter feuchter Luft arbeiten kann. Im Unterschied zu anderen Arten von Wärmepumpen, ist das Peltierelement jedoch schnell einsetzbar, ist jederzeit ab- und/oder zuschaltbar und erfordert lediglich einen geringen Bauraum.

Der erste Fluidwärmetauscher in dieser bevorzugten Ausgestaltung des Reinigungsgeräts kann insbesondere von dem ersten Kühlfluid durchströmt werden, wobei das erste Kühlfluid nach Durchströmen des ersten Fluidwärmetauschers die Fluidheizvorrichtung des Peltierelements durchströmt. Diese Ausgestaltung bewirkt, dass die erste Wärmemenge, welche in dem ersten Fluidwärmetauscher der feuchten Luft entzogen wird, vom ersten Kühlfluid aufgenommen wird. Anschließend wird in dieses erste Kühlfluid noch zusätzlich die vom Peltierelement übertragene zweite Wärmemenge hinzugefügt, so dass das erste Kühlfluid auf vergleichsweise hohe Temperaturen aufgeheizt werden kann. Im Gegensatz zu üblichen, reinen Flüssigkeitswärmetauschern kann somit das Kühlfluid bereits zumindest näherungsweise auf die in einer anschließenden Reinigung des Reinigungsguts benötigten Temperaturen oder sogar über diese Temperaturen hinaus aufgeheizt werden, so dass eine besonders hohe Energieeffizienz des Reinigungsgerätes gewährleistet werden kann.

Naturgemäß kann das oben beschriebene mehrstufige Prinzip der Wärmerückgewinnungseinrichtung auch erweitert werden, beispielsweise von dem beschriebenen einen ersten Fluidwärmetauscher, an welchen sich ein Peltierelement anschließt, auf mehrere, hintereinander geschaltete Fluidwärmetauscher und/oder mehrere, hintereinander geschaltete Peltierelemente.

Der erste Fluidwärmetauscher kann insbesondere mindestens eine von dem ersten Kühlfluid durchströmte offene Kühlfluidleitung umfassen. Diese offene Kühlfluidleitung kann an einem Abstromende mit der Fluidheizvorrichtung des Peltierelements verbunden sein. Weiterhin kann an einem Zustromende die Kühlfluidleitung mit einem Kaltwasseranschluss verbunden sein. Zwischen Zustromende und Abstromende kann der Fluidwärmetauscher beispielsweise Kühlschlangen, Kühlbleche (beispielsweise durchströmte und/oder überströmte Kühlbleche) und/oder andere Arten bekannter Wärmetauscher umfassen, welche eingerichtet sind, um der feuchten Luft die erste Wärmemenge zu entziehen.

Wie oben erwähnt, kann das mindestens eine Peltierelement direkt oder indirekt mit der feuchten Luft in Kontakt geraten, um dieser die zweite Wärmemenge zu entziehen. Unter einer "direkten" Kopplung kann dabei beispielsweise eine Kopplung verstanden werden, bei welcher die feuchte Luft beispielsweise unmittelbar die Wärmeaufnahmeseite des Peltierelements und/oder eine mit dieser Wärmeaufnahmeseite thermisch gekoppelte Fläche überströmt. Dies kann beispielsweise analog zur in der DE 198 13 924 A1 beschriebenen Ausgestaltung geschehen, in welcher die wärmeaufnehmende Fläche unmittelbar mit dem zu kühlenden Medium in Verbindung steht. Auch eine komplexere Ausgestaltung der unmittelbar von dem Peltierelement gekühlten Fläche ist denkbar, beispielsweise in Form einer ebenfalls in DE 198 13 924 A1 beschriebenen Ausgestaltung der Wärmeaufnahmeseite in Form großer Oberflächen, beispielsweise in Form von Kammern oder Zwischenräumen, welche von der feuchten Luft durchströmt werden können. Auf diese Weise ist eine besonders effiziente Wärmeübertragung möglich.

Besonders bevorzugt ist es im Rahmen der vorliegenden Erfindung jedoch, wenn der Wärmeübertrag von der feuchten Luft auf das Peltierelement ganz oder teilweise indirekt erfolgt. Zu diesem Zweck kann die Wärmerückgewinnungseinrichtung beispielsweise weiterhin mindestens einen zweiten Fluidwärmetauscher aufweisen, welcher von einem zweiten Kühlfluid durchströmt wird. Bezüglich der möglichen Ausgestaltungen dieses Kühlfluids kann beispielsweise auf die obige Beschreibung des ersten Kühlfluids verwiesen werden, wobei jedoch in diesem Fall auch eine unterschiedliche Ausgestaltung gewählt werden kann. Insbesondere ist es bevorzugt, wenn dieses zweite Kühlfluid anschließend nicht als Reinigungsfluid verwendet wird, so dass hinsichtlich der Auswahl geeigneter Materialien für dieses zweite Kühlfluid eine höhere Freiheit besteht.

Das zweite Kühlfluid steht vorzugsweise in mindestens einer Fluidkühlvorrichtung in thermischem Kontakt mit der Wärmeaufnahmeseite des Peltierelements. Dieser thermische Kontakt kann beispielsweise durch geeignete Wärmeübertragungselemente hergestellt werden. Auf diese Weise kann das zweite Kühlfluid beispielsweise zunächst die zweite Wärmemenge von der feuchten Luft aufnehmen, diese zweite Wärmemenge dann hin zu der Fluidkühlvorrichtung transportieren, wo dann diese zweite Wärmemenge an das Peltierelement übertragen wird. Der Wärmeübertrag zwischen feuchter Luft und Peltierelement erfolgt hiermit also indirekt.

Wie oben beschrieben, kann das mindestens eine Peltierelement auf unterschiedliche Weisen ausgestaltet sein. So können beispielsweise einzelne Peltierelemente eingesetzt werden, welche auch parallel nebeneinander geschaltet werden können, beispielsweise um die effektive Fläche der Wärmeaufnahmeseite und/oder der Abwärmeseite zu erhöhen (parallele Anordnung). Alternativ oder zusätzlich zu einer parallelen Anordnung einzelner Peltierelemente ist jedoch auch eine Stapelung mehrerer Peltierelemente möglich (gestapelte Anordnung). So können vorteilhaft auch mehrere Peltierelemente kaskadenartig in Peltierstapeln mit je einer Wärmeaufnahmeseite und je einer Abwärmeseite gestapelt angeordnet sein. Diese Anordnung erfolgt sinnvoller Weise derart, dass je eine Wärmeaufnahmeseite und je eine Abnahmeseite benachbarter Peltierelemente in thermischem Kontakt zueinander stehen. Auf diese Weise kann durch geeignete Stapelung der Peltierelemente beispielsweise die Temperaturdifferenz zwischen Abwärmeseite und Wärmeaufnahmeseite, welche erreichbar ist, erhöht werden.

Wenn Peltierstapel der beschriebenen Art eingesetzt werden, jedoch möglicherweise auch, wenn einzelne Peltierelemente ungestapelt eingesetzt werden, so ist eine im Nachfolgenden beschriebene vorteilhafte Ausgestaltung möglich, bei welcher mehrere derartiger einzelner Peltierelemente und/oder Peltierstapel hinsichtlich ihrer Wärmeaufnahmeseiten und ihrer Abwärmeseiten alternierend angeordnet sind und zu einem Peltiermodul zusammengefasst sind. Unter einer "alternierenden Anordnung" sind dabei Anordnungen zu verstehen, bei welcher jeweils die Abwärmeseiten benachbarter Peltierstapel einander zuweisen und/oder bei welcher jeweils die Wärmeaufnahmeseiten benachbarter Peltierstapel einander zuweisen. Zwischen den Peltierstapeln können dann jeweils Wärmeaustauschbereiche angeordnet sein, welche mit den Peltierstapeln in thermischem Kontakt stehen. Unter "einander zuweisen" ist somit eine beliebige Anordnung zu verstehen, in welcher mindestens zwei Wärmeaufnahmeseiten verschiedener Peltierstapel einem Wärmeaustauschbereich zuweisen bzw. in welcher mindestens zwei Abwärmeseiten verschiedener Peltierstapel einem Wärmeaustauschbereich zuweisen, wobei natürlich auch komplexere Anordnungen als eine lineare Anordnung der Peltierstapel (beispielsweise sternförmige Anordnungen) denkbar sind. Dabei kann jeweils mindestens ein erster Wärmeaustauschbereich mit mindestens zwei Abwärmeseiten der Peltierstapel, welche an diesen ersten Wärmeaustauschbereich angrenzen, in thermischem Kontakt stehen. Jeweils mindestens ein zweiter Wärmeaustauschbereich kann derart angeordnet sein, dass dieser mit mindestens zwei Wärmeaufnahmeseiten der Peltierstapel in thermischem Kontakt steht. Auf diese Weise kann beispielsweise eine Schichtstruktur geschaffen werden, bei welcher jeweils Wärmeaustauschbereiche und Peltierstapel abwechselnd angeordnet sind. Dies kann beispielsweise im Rahmen eines lamellenartigen Aufbaus des Peltiermoduls geschehen, so dass eine besonders Platz sparende Bauweise bei gleichzeitig hoher Effizienz des Wärmeaustauschs möglich ist. Auch andere Arten des Aufbaus sind jedoch denkbar.

Der erste Wärmeaustauschbereich kann beispielsweise genutzt werden, um Wärme der Abwärmeseite einzelner Peltierelemente bzw. der Peltierstapel auf das erste Kühlfluid zu übertragen. So kann der erste Wärmeaustauschbereich beispielsweise mindestens einen Hohlraum umfassen, welcher von dem ersten Kühlfluid durchströmt wird. Im Rahmen des beschriebenen lamellenartigen Aufbaus können diese Hohlräume beispielsweise als Hohlplatten ausgestaltet sein, welche von dem mindestens einen ersten Kühlfluid durchströmt werden, so dass eine hohle Fläche für den Wärmeaustausch zur Verfügung steht.

Entsprechend kann der mindestens eine zweite Wärmeaustauschbereich genutzt werden, um effizient Wärme von der feuchten Luft auf die Wärmeaufnahmeseiten der Peltierelemente bzw. der Peltierstapel zu übertragen. Wie oben beschrieben, kann dies beispielsweise dadurch erfolgen, dass der zweite Wärmeaustauschbereich mindestens einen Hohlraum (beispielsweise wiederum einen oder mehrere Hohlräume von Hohlplatten) umfasst, welche unmittelbar von der feuchten Luft durchströmt werden. Alternativ oder zusätzlich kann jedoch wiederum auch ein indirekter Wärmeaustausch mittels eines zweiten Kühlfluids erfolgen. So kann das zweite Kühlfluid beispielsweise wiederum den mindestens einen Hohlraum des zweiten Wärmeaustauschbereichs (beispielsweise Hohlplatten) durchströmen, so dass ein besonders effizienter Wärmeübertrag stattfinden kann.

Wie oben beschrieben, liegt ein besonderer Vorteil bei der Verwendung von Peltierelementen in Wärmerückgewinnungseinrichtungen darin, dass Peltierelemente, im Gegensatz beispielsweise zu herkömmlichen Wärmepumpen, flexibel zu- und/oder abschaltbar und/oder ansteuerbar sind. Dies kann gezielt eingesetzt werden, um die Funktionalität der Wärmerückgewinnungseinrichtung zu steuern und/oder zu überwachen.

So kann beispielsweise die Wärmerückgewinnungseinrichtung mindestens einen Temperatursensor zum Erfassen einer Temperatur der feuchten Luft und/oder mindestens einen Feuchtigkeitssensor zum Erfassen einer Feuchtigkeit der feuchten Luft aufweisen. Dieser mindestens eine Temperatursensor bzw. Feuchtigkeitssensor kann an verschiedenen Stellen im Luftstrom der feuchten Luft angeordnet sein. So kann beispielsweise mindestens ein Temperatursensor und/oder Feuchtigkeitssensor vor dem bzw. den oben beschriebenen Wärmetauschern, innerhalb dieser Elemente und/oder diesen Elementen nachgeordnet angeordnet sein, so dass beispielsweise an verschiedenen Stellen Temperaturen erfasst werden können. Insbesondere kann eine Endtemperatur erfasst werden, welche beispielsweise die Temperatur der Abluft vor Abgabe in die Umgebung und/oder an eine Ablufteinrichtung (beispielsweise ein bauseitiges Abluftrohr) überwachen kann. Werden Grenzwerte überschritten, so können beispielsweise Warnungen an einen Benutzer ausgegeben werden und/oder aktiv Prozesse, beispielsweise Steuerungs- oder Regelungsprozesse, initiiert werden. Neben einem oder mehreren Temperatursensoren können, alternativ oder zusätzlich, auch andere Arten von Sensoren vorgesehen sein, beispielsweise Feuchtigkeitssensoren oder andere Arten von Sensoren.

Besonders bevorzugt ist es, wenn die Wärmerückgewinnungseinrichtung weiterhin mindestens eine elektronische Steuervorrichtung umfasst. Diese elektronische Steuervorrichtung, welche beispielsweise ganz und/oder teilweise in eine zentrale Steuereinrichtung des Reinigungsgeräts integriert sein kann, welche jedoch auch als autarke bzw. dezentrale Steuereinrichtung ausgestaltet sein kann, kann zum Steuern der Funktionalität der Wärmerückgewinnungseinrichtung eingesetzt werden. So kann diese elektronische Steuereinrichtung beispielsweise zum Steuern und/oder Regeln der Ablufttemperatur und/oder der Abluftfeuchtigkeit eingesetzt werden. Zu diesem Zweck kann die elektronische Steuervorrichtung beispielsweise eingerichtet sein, um eine Kühlleistung des mindestens einen Peltierelements zu steuern und/oder zu regeln. Beispielsweise kann entsprechend einem Steuer-und/oder Regelsignal ein durch das mindestens eine Peltierelement fließender elektrischer Strom gesteuert und/oder geregelt werden. Die elektronische Steuerungsvorrichtung kann beispielsweise auch das Umschalten zwischen Standby-Betrieb und einem Betriebszustand steuern, sowie gegebenenfalls die Einleitung der Übergangsphase. Zu diesem Zweck kann die Steuerungsvorrichtung beispielsweise mit weiteren Sensoren in Kontakt stehen, beispielsweise Sensoren, die den Zustand des Latentwärmespeichers ("Ladezustand") erfassen, also beispielsweise erfassen, welche Temperatur dieser Latentwärmespeicher hat und/oder zu welchem Anteil ein Phasenübergang in dem Latentwärmespeicher, beispielsweise ein fest-flüssig-Phasenübergang, stattgefunden hat, um entsprechend beispielsweise die Übergangsphase zu steuern.

Wie oben beschrieben, ist die Erfindung insbesondere im Rahmen gewerblicher Reinigungsgeräte, insbesondere gewerblicher Geschirrspülmaschinen, einsetzbar. Insbesondere ist es bevorzugt, wenn der Fluidtank einen Boiler und/oder einen Durchlauferhitzer umfasst. Wie oben beschrieben, kann das Reinigungsgerät beispielsweise eine Durchlaufgeschirrspülmaschine mit mindestens einer Reinigungszone umfassen, wobei das Reinigungsgut diese mindestens eine Reinigungszone in einer Durchlaufrichtung durchläuft. Die mindestens eine Reinigungszone kann beispielsweise mindestens eine Pumpenklarspülzone und/oder eine Frischwasserklarspülzone umfassen, welche in der Regel eine besonders hohe Temperatur des Reinigungsfluids (Klarspülflüssigkeit) aufweist, beispielsweise eine Temperatur von ca. 85 °C. Für die Wärmerückführung eignet sich daher insbesondere der Pumpenklarspültank der Pumpenklarspülzone und/oder eine Verwendung in der Frischwasserklarspülzone (beispielsweise in Form einer direkten Zuführung und/oder in Form einer Zuführung in einen Frischwasserklarspültank).

Neben der mindestens einen Reinigungszone kann die Durchlaufgeschirrspülmaschine weiterhin mindestens eine Trocknungszone aufweisen, welche vorzugsweise der mindestens einen Reinigungszone in Durchlaufrichtung nachgeordnet ist. Diese Trocknungszone kann insbesondere ein Gebläse aufweisen, um das Reinigungsgut mit Warmluft zu beaufschlagen. Besonders bevorzugt ist es in diesem Fall, wenn das Gebläse und die Absaugvorrichtung derart eingerichtet sind bzw. zusammenwirken, dass sich im Betrieb ein der Durchlaufrichtung entgegengerichteter Luftstrom in der Durchlaufgeschirrspülmaschine ausbildet. Diese Weiterbildung der Erfindung hat insbesondere den Vorteil, dass die feuchte Luft innerhalb der Reinigungszonen mit zunehmender Feuchtigkeitsaufnahme der Durchlaufrichtung entgegengesetzt geleitet wird, um schließlich, beispielsweise in einer ersten Reinigungszone, abgesaugt zu werden. Die feuchte Luft hat somit vorzugsweise Abwärme aus sämtlichen Zonen der Geschirrspülmaschine aufgenommen und weist somit eine besonders hohe Temperatur für die Wärmerückgewinnung auf.

Neben dem Reinigungsgerät in einer der oben beschriebenen Ausführungsformen wird weiterhin ein Verfahren zur Wärmerückgewinnung in einem Reinigungsgerät vorgeschlagen. Dieses Verfahren ist insbesondere in einem Reinigungsgerät gemäß einer der oben beschriebenen Ausführungsformen einsetzbar, so dass für mögliche Ausführungsbeispiele des verwendeten Reinigungsgeräts weitgehend auf die obige Beschreibung verwiesen werden kann. Auch in anderen Ausgestaltungen von Reinigungsgeräten ist das Verfahren jedoch prinzipiell einsetzbar.

Das Reinigungsgerät ist eingerichtet, um das Reinigungsgut in mindestens einer Reinigungskammer mit mindestens einem Reinigungsfluid zu beaufschlagen (Betriebszustand, Normalbetrieb, Reinigungsbetrieb). Das Reinigungsgerät weist eine Absaugvorrichtung zum Absaugen von feuchter Luft aus der Reinigungskammer auf, sowie mindestens eine Wärmerückgewinnungseinrichtung. Letztere ist eingerichtet, um der feuchten Luft Wärme zu entziehen und dem Reinigungsgerät über ein erstes Kühlfluid wieder zuzuführen. Das Reinigungsgerät weist eine Kühlfluidleitung mit mindestens einem Rückführpfad sowie mindestens einem Wärmespeicherpfad mit mindestens einem Latentwärmespeicher auf. Das Verfahren ist derart ausgestaltet, dass das erste Kühlfluid in mindestens einem Betriebszustand nach Durchströmen der Wärmerückgewinnungseinrichtung über den Rückführpfad zu der Reinigungskammer und/oder in einen Fluidtank geleitet wird. In einem Standby-Betrieb wird das erste Kühlfluid über den Wärmespeicherpfad dem Latentwärmespeicher zugeführt, so dass dieses erste Kühlfluid Wärme von der Wärmerückgewinnungseinrichtung auf den Latentwärmespeicher übertragen kann.

Wie oben ausgeführt, kann nach Beendigung des Standby-Betriebs und/oder nach Beginn des Betriebszustands, beispielsweise während einer Übergangsphase, die in dem Latentwärmespeicher gespeicherte Wärme zumindest teilweise unter Zuhilfenahme eines Fluids, insbesondere des ersten Kühlfluids und/oder eines separaten Transferfluids, zu der Reinigungskammer und/oder in den Fluidtank überführt werden, um so dem Reinigungsprozess wieder zugeführt zu werden.

Für weitere mögliche Ausgestaltungen des Verfahrens kann auf die obige Beschreibung verwiesen werden, da die bestimmungsgemäßen Verwendungen bzw. Betriebsweisen der einzelnen Ausgestaltungen des Reinigungsgerätes entsprechende Verfahrensschritte implizieren.

Insbesondere kann, wie oben beschrieben, die Wärmerückgewinnungseinrichtung mindestens ein Peltierelement aufweisen, welches über mindestens eine Wärmeaufnahme und mindestens eine Abwärmeseite verfügt. Das Verfahren kann dann derart durchgeführt werden, dass feuchter Luft aus dem Reinigungsgerät mittels der Aufnahmeseite Wärme entzogen wird, wobei die Abwärmeseite des Peltierelements mittels des ersten Kühlfluids gekühlt wird. Dieses erste Kühlfluid kann anschließend in den Rückführpfad und/oder in den Wärmespeicherpfad überführt werden. Auf diese Weise kann die an der Abwärmeseite des Peltierelements aufgenommene Wärme zumindest teilweise dem Reinigungsgerät bzw. dem Latentwärmespeicher wieder zugeführt werden. Dieses erste Kühlfluid kann anschließend beispielsweise für eine Reinigung des Reinigungsgutes verwendet werden. Die Wiederverwendung kann insbesondere kontinuierlich und/oder auch sequentiell erfolgen, je nach Ausgestaltung des Reinigungsgeräts.

Wie oben beschrieben, kann die Wärmerückgewinnung auch kaskadiert bzw. mehrstufig ausgebildet sein. So kann die Wärmerückgewinnungseinrichtung beispielsweise mindestens einen ersten Fluidwärmetauscher aufweisen, welcher eingerichtet ist, um der feuchten Luft eine erste Wärmemenge zu entziehen. Die Wärmeaufnahmeseite des Peltierelements kann eingerichtet sein, um der feuchten Luft eine zweite Wärmemenge zu entziehen, wobei das erste Kühlfluid zunächst den ersten Fluidwärmetauscher durchströmt und anschließend die Abwärmeseite des Peltierelements kühlt.

Wie ebenfalls oben beschrieben, kann das Verfahren weiterhin in vorteilhafter Weise derart weitergebildet werden, dass eine Temperatur und/oder eine Feuchtigkeit der feuchten Luft nach Durchströmen der Wärmerückgewinnungseinrichtung gesteuert und/oder geregelt wird, indem mindestens eine Kühlleistung des Peltierelements gesteuert und/oder geregelt wird.

Das Reinigungsgerät ist eingerichtet, um das Reinigungsgut mit mindestens einem Reinigungsfluid zu beaufschlagen, wobei das Reinigungsgerät mindestens eine Wärmerückgewinnungseinrichtung aufweist, welche eingerichtet ist, um der feuchten Luft Wärme zu entziehen. Wie oben beschrieben, weist die Wärmerückgewinnungseinrichtung mindestens ein Peltierelement auf, welches über mindestens eine Wärmeaufnahmeseite und mindestens eine Abwärmeseite verfügt. Das Verfahren wird derart durchgeführt, dass feuchter Luft aus dem Reinigungsgerät mittels der Aufnahmeseite Wärme entzogen wird, wobei die Abwärmeseite des Peltierelements mittels eines ersten Kühlfluids gekühlt wird. Dieses erste Kühlfluid wird anschließend in den Fluidtank geleitet, um die an der Abwärmeseite des Peltierelements aufgenommene Wärme zumindest teilweise dem Reinigungsgerät wieder zuzuführen. Dieses Kühlfluid kann anschließend beispielsweise für eine Reinigung des Reinigungsgutes verwendet werden. Diese Wiederverwendung kann beispielsweise kontinuierlich und/oder auch sequentiell erfolgen, je nach Ausgestaltung des Reinigungsgeräts.

Wie ebenfalls oben beschrieben, kann die Wärmerückgewinnung auch kaskadiert bzw. mehrstufig ausgebildet sein. So kann die Wärmerückgewinnungseinrichtung beispielsweise mindestens einen ersten Fluidwärmetauscher aufweisen, welcher eingerichtet ist, um der feuchten Luft eine erste Wärmemenge zu entziehen. Die Wärmeaufnahmeseite des Peltierelements kann eingerichtet sein, um der feuchten Luft eine zweite Wärmemenge zu entziehen, wobei das erste Kühlfluid zunächst den ersten Fluidwärmetauscher durchströmt und anschließend die Abwärmeseite des Peltierelements kühlt.

Wie ebenfalls oben beschrieben, kann das Verfahren weiterhin in vorteilhafter Weise derart weitergebildet werden, dass eine Temperatur und/oder eine Feuchtigkeit der feuchten Luft nach Durchströmen der Wärmerückgewinnungseinrichtung gesteuert und/oder geregelt wird, indem mindestens eine Kühlleistung des Peltierelements gesteuert und/oder geregelt wird.

### Ausführungsbeispiele

Weitere Einzelheiten und Merkmale der Erfindung ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Erfindung ist nicht auf die Ausführungsbeispiele beschränkt. Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente.

### Im Einzelnen zeigt:

- Figur 1: ein Ausführungsbeispiel eines Reinigungsgeräts in Form einer Durchlaufgeschirrspülmaschine;
- Figur 2: eine schematische Darstellung eines Ausführungsbeispiels einer Wärmerückgewinnungseinrichtung;
- Figur 3: ein mögliches Ausführungsbeispiel einer Peltier-Anordnung.
- Figur 4: einen schematischen Ablaufplan eines Ausführungsbeispiels eines erfindungsgemäßen Verfahrens zum Betrieb des Reinigungsgerätes.

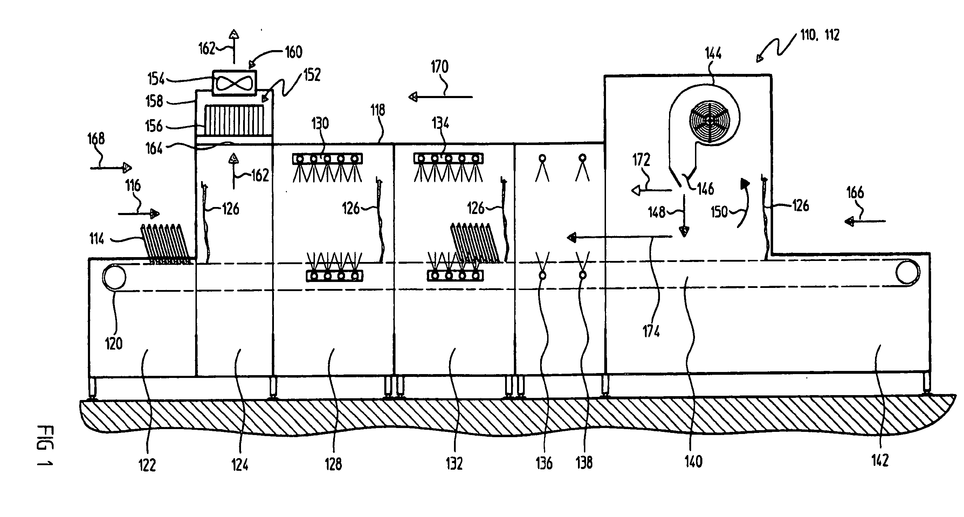

In Figur 1 ist ein mögliches Ausführungsbeispiel eines erfindungsgemäßen Reinigungsgeräts 110 dargestellt. Dieses Reinigungsgerät ist in diesem Ausführungsbeispiel als Durchlaufgeschirrspülmaschine 112 ausgestaltet. Für den Aufbau und die Funktionsweise dieser Durchlaufgeschirrspülmaschine 112 kann weitgehend auf die DE 10 2004 003 797 A1 verwiesen werden.

In der Durchlaufgeschirrspülmaschine 112 durchläuft Reinigungsgut 114 in einer Durchlaufrichtung 116 eine Reinigungskammer 118. Der Transport des Reinigungsguts erfolgt in der dargestellten Durchlaufgeschirrspülmaschine 112 mittels eines Transportbandes 120. Die Durchlaufgeschirrspülmaschine 112 ist somit als Bandtransport-Geschirrspülmaschine ausgestaltet.

An einem Einlauf 122 läuft auf der Oberseite des Transportbandes 120 aufgenommenes Reinigungsgut 114 in einen Einlauftunnel 124 ein. Der Einlauftunnel 124 ist mittels eines Trennvorhangs 126 nach außen abgeschirmt, um den Austritt von Dampfwrasen im Bereich des Einlauftunnels 124 der Durchlaufgeschirrspülmaschine 112 zu verhindern. Nachdem das an der Oberseite des Transportbandes 120 aufgenommene Reinigungsgut 114 den Einlauftunnel 124 passiert hat, tritt es in die Reinigungskammer 118 ein, welche in mehrere Reinigungszonen unterteilt ist. Zunächst wird das Reinigungsgut 114 in eine Vorspülzone 128 transportiert. Innerhalb der Vorspülzone 128 ist ein Vorspülsystem 130 angeordnet. Das Vorspülsystem 130 weist Sprührohre auf, welche an der Unterseite bzw. oberhalb des umlaufenden Transportbandes 120 angeordnet sind. Über eine in Figur 1 nicht dargestellte, in ihrer Leistung regelbare Pumpe wird das Vorspülsystem 130 je nach Verschmutzungsgrad des Reinigungsguts 114 mit Reinigungsfluid beaufschlagt. Die Vorspülzone 128 ist über einen weiteren Trennvorhang 126 von einer sich anschließenden Spülzone 132 getrennt. Nach Passage der Vorspülzone 128 läuft das Reinigungsgut 114 in die Spülzone 132 ein. Die Spülzone 132 umfasst ebenfalls ein Spülsystem, bezeichnet durch das Bezugszeichen 134. Das Spülsystem 134 ist oberhalb und unterhalb der Oberseite des umlaufenden Transportbandes 120 angeordnet. Die Spülzone 132 ist durch einen weiteren Trennvorhang 126 von einer Pumpenklarspülzone 136 getrennt, welche ein oberhalb und ein unterhalb der Oberseite des Transportbandes 120 angeordnetes Spülsystem in Gestalt von zwei einander gegenüberliegenden Sprührohren aufweist. An die Pumpenklarspülzone 136 schließt sich eine Frischwasserklarspülzone 138 an. Innerhalb der Frischwasserklarspülzone 138 wird das Reinigungsgut 114 mit Frischwasser abgespült, um verbliebene Verunreinigungen bzw. das zuvor aufgebrachte Reinigungsfluid vor Eintritt des Reinigungsguts in eine Trocknungszone 140 von diesem zu entfernen. Der Frischwasserklarspülzone 138 nachgeschaltet befindet sich ein (in Figur 1 nicht dargestellter) weiterer Trennvorhang 126, welcher die Frischwasserklarspülzone 138 von der Trocknungszone 140 trennt.

Innerhalb der Trocknungszone 140, welcher eine Abnahmestrecke 142 nachgeschaltet ist, befindet sich ein Trocknungsgebläse 144. Das Trocknungsgebläse 144 saugt Luft an und erwärmt diese. Die im Trocknungsgebläse 144 erwärmte Luft tritt in einen Austrittstrichter 146 ein, an dessen unterem Ende sich eine Austrittsdüse befindet, welche die austretende Trocknungsluft auf das die Trocknungszone 144 passierende Reinigungsgut 114 lenkt. Unterhalb der Trocknungszone 144 kann eine Umlenkfläche vorgesehen sein, welche die in Austrittsrichtung 148 aus der Austrittsdüse austretende Warmluft in Strömungsrichtung 150 umlenkt, so dass diese teilweise wieder dem Trocknungsgebläse 144 zuströmt. In Durchlaufrichtung 116 des Reinigungsguts 114 gesehen, ist die Trocknungszone 144 über einen weiteren Trennvorhang 126 gegen die Abnahmestrecke 142 abgeschirmt.

Während des Transports des Reinigungsguts 114 durch die in Figur 1 dargestellte Durchlaufgeschirrspülmaschine 112 nimmt dessen Temperatur kontinuierlich zu. Von Raumtemperatur an steigt die Temperatur des Reinigungsguts 114 in der Vorspülzone 128 beispielsweise auf eine Temperatur von 40 °C bis 45 °C, in der sich daran anschließenden Spülzone 132 auf 55 °C bis 65 °C und in der sich daran anschließenden Pumpenklarspülzone 136 bzw. Frischwasserklarspülzone 138 auf eine Temperatur zwischen 60 °C und 85 °C an.

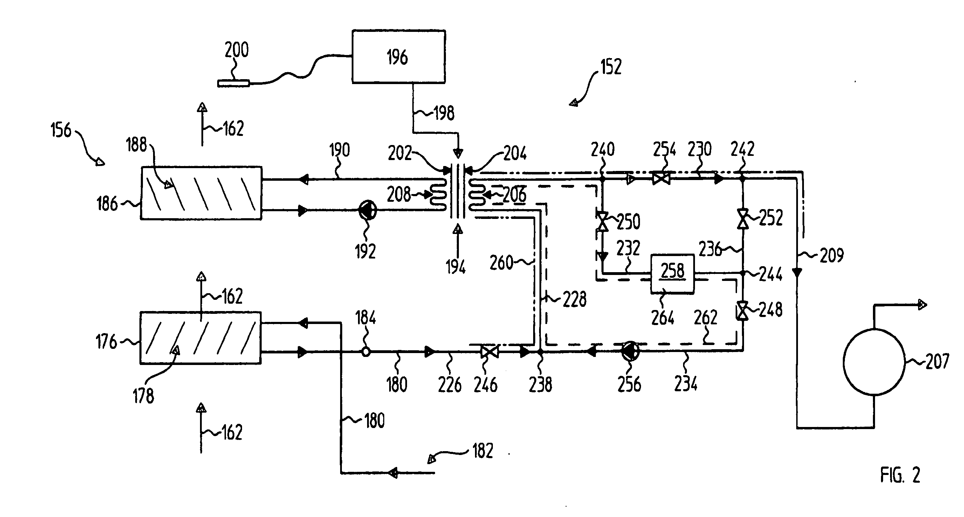

Die Durchlaufgeschirrspülmaschine 112 weist eine Wärmerückgewinnungseinrichtung 152 auf, welche ein Gebläse 154 und eine Wärmetauscheinrichtung 156 umfasst. Beide sind in einem Schacht 158 angeordnet, welcher in einer Abluftöffnung 160 mündet, in deren Bereich das Gebläse 154 angeordnet ist. Der Schacht 158 ist in diesem Ausführungsbeispiel im Bereich oberhalb des Einlauftunnels 124 angeordnet. Die Ausgestaltung der Wärmetauscheinrichtung 156 und der Wärmerückgewinnungseinrichtung 152 wird nachfolgend anhand der Figuren 1 und 2 näher erläutert. Über das der Wärmerückgewinnungseinrichtung 152 zugeordnete Gebläse 154 wird innerhalb der Durchlaufgeschirrspülmaschine 112 ein Unterdruck erzeugt, der die Absaugung eines Abluftstroms 162 an einer Absaugstelle 164 ermöglicht. Wie oben dargestellt, ist diese Absaugstelle 164 im vorliegenden Ausführungsbeispiel oberhalb des Einlauftunnels 124 angeordnet, wobei jedoch auch andere Ausgestaltungen möglich sind, beispielsweise Anordnungen der Absaugstelle 164 in einer oder mehreren der Reinigungszonen 128, 132, 136 oder 138. Durch die Absaugung des Abluftstroms 162 an der Absaugstelle 164 wird verhindert, dass am Einlauf 122 und an der Abnahmestrecke 142 Dampfwrasen aus der Durchlaufgeschirrspülmaschine 112 austreten. Dazu dienen einerseits die dort angeordneten Trennvorhänge 126 und andererseits das einen Unterdruck erzeugende Gebläse 154. Unterhalb der Trennvorhänge 126 am Einlauftunnel 124 und an der Abnahmestrecke 142 befinden sich spaltförmige Öffnungen, über welche jeweils Außenluftströme 166, 168 in die Durchlaufgeschirrspülmaschine 112 eintreten und welche dem Gesamtvolumen des Abluftstromes 162 entsprechen. Die Luftführung innerhalb der Durchlaufgeschirrspülmaschine 112 gemäß der Darstellung in Figur 1 ist derart gewählt, dass der Abluftstrom 162 die verschiedenen, vom Reinigungsgut 114 durchlaufenen Reinigungszonen 128, 132, 136, 138 entgegen der Durchlaufrichtung 116 durchströmt, wie durch das Bezugszeichen 170 angedeutet ist. Die Strömung 170 des Abluftstroms 162 wird einerseits durch das der Wärmerückgewinnungseinrichtung 152 zugeordnete Gebläse 154 und andererseits durch das Trocknungsgebläse 144 herbeigeführt. Vorzugsweise kann das Trocknungsgebläse 144 variabel ausgestaltet sein. Je nach Neigung der Austrittsdüsen des Trocknungsgebläses 144 kann beispielsweise aus der Trocknungszone 140 eine erste, kleinere Luftmenge 172 bzw. eine zweite, größere Luftmenge 174 abgezogen werden. Diese Luftmengen 172, 174 können durch eine entsprechende Steuerung des Trocknungsgebläses 144 und des Gebläses 154 eingestellt werden, so dass keine Dampfwrasen aus der Durchlaufgeschirrspülmaschine 112 austreten können.

Für weitere mögliche Ausgestaltungen der Durchlaufgeschirrspülmaschine 112 sei beispielsweise auf die DE 10 2004 003 797 A1 verwiesen. Es sei jedoch darauf hingewiesen, dass die Reinigungsgeräte 110 auch auf andere Weise ausgestaltet sein können, beispielsweise mit einer einzelnen Reinigungskammer, welche mit einer Wärmerückgewinnungseinrichtung 152 ausgestattet ist. Auch eine Ausgestaltung mit mehreren Reinigungskammern, bei welchen jeweils eine oder mehrere Wärmerückgewinnungseinrichtungen vorgesehen sind, ist denkbar.

In Figur 2 ist ein mögliches Ausführungsbeispiel der Wärmerückgewinnungseinrichtung 152 schematisch dargestellt, welche beispielsweise in dem Reinigungsgerät 110 nach Figur 1 eingesetzt werden kann. Nicht dargestellt ist dabei das Gebläse 154, welches den Abluftstrom 162 warmer, feuchter Luft durch eine Wärmetauscheinrichtung 156 bewirkt und/oder eine andere Art der Einrichtung, welche den Austrag dieser feuchten Luft begünstigt.

Die Wärmetauscheinrichtung 156 umfasst einen ersten Fluidwärmetauscher 176, welcher in Figur 2 lediglich angedeutet ist. Dieser erste Fluidwärmetauscher 176 kann beispielsweise eine Vielzahl von ersten Wärmetauscherflächen 178 umfassen, welche beispielsweise in Form von Kühlschlangen, Kühlflächen, durchströmten und/oder überströmten Kühlblechen, Lamellen oder auf ähnliche, dem Fachmann bekannte Weise ausgestaltet sein können. Weiterhin weist der erste Fluidwärmetauscher 176 eine Kühlfluidleitung 180 mit einem Zustromende 182 und einem Abstromende 184 auf. Ein erstes Kühlfluid kann den ersten Fluidwärmetauscher 176 vom Abstromende 184 her durchströmen, durchströmt dann die ersten Wärmetauscherflächen 178, um schließlich zum Abstromende 184 zu strömen. Das Zustromende 182 kann beispielsweise mit einem Kaltwasseranschluss (Frischwasser) verbunden sein.

Die Wärmetauscheinrichtung 156 weist weiterhin einen zweiten Fluidwärmetauscher 186 auf. Dieser zweite Fluidwärmetauscher 186 kann grundsätzlich ähnlich zu dem ersten Fluidwärmetauscher 176 ausgestaltet sein und kann beispielsweise wiederum zweite Wärmetauscherflächen 188 aufweisen. Diese können beispielsweise wiederum durchströmte oder übersprühte Kühlflächen, Kühlschlangen, Lamellen oder ähnliche Arten von Wärmetauscherflächen aufweisen, wie sie auch in den ersten Wärmetauscherflächen 178 eingesetzt werden können. Der zweite Fluidwärmetauscher 186 umfasst einen von einem zweiten Kühlfluid durchströmten Wärmetauscherkreislauf 190, so dass der zweite Fluidwärmetauscher 186 insgesamt ein geschlossenes System bildet, in welchem ein zweites Kühlfluid zirkulieren kann. Diese Zirkulation kann beispielsweise durch eine Pumpe 192 in dem Wärmetauscherkreislauf 190 unterstützt werden. Es sei darauf hingewiesen, dass auch an anderen Stellen in der in Figur 2 dargestellten Wärmerückgewinnungseinrichtung 152 Pumpen, Ventile oder ähnliche, die Fluidbewegung vorantreibende bzw. steuernde Vorrichtungen aufgenommen seien können, welche in Figur 2 nicht dargestellt sind.

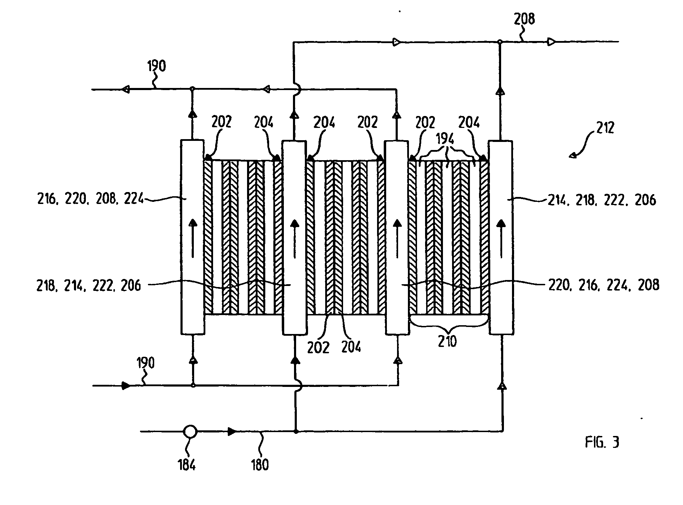

Weiterhin umfasst die Wärmetauschereinrichtung 156 Peltierelemente 194, welche in Figur 2 lediglich angedeutet sind und für deren genauen Aufbau beispielsweise auf die Figur 3 unten verwiesen werden kann. Die Peltierelemente 194 werden durch eine elektronische Steuervorrichtung 196 mit elektrischer Energie versorgt, beispielsweise mit einem elektrischen Strom beaufschlagt. Dies ist in Figur 2 symbolisch durch die Steuerleitung 198 angedeutet. Weiterhin ist die elektronische Steuervorrichtung 196 mit einem Temperatursensor 200 verbunden, beispielsweise einem temperaturabhängigen Messwiderstand, welcher im Abluftstrom 162 abstromseitig des zweiten Fluidwärmetauschers 186 angeordnet ist. Alternativ oder zusätzlich zu dieser Anordnung des Temperatursensors 200 können auch andere Anordnungen von Temperatursensoren und/oder Anordnungen von Feuchtigkeitssensoren (nicht dargestellt) gewählt werden, beispielsweise Anordnungen zwischen dem ersten Fluidwärmetauscher 176 und dem zweiten Fluidwärmetauscher 186 und/oder eine Anordnung vor dem ersten Fluidwärmetauscher 176.

Die Peltierelemente 194 weisen eine Wärmeaufnahmeseite 202 und eine Abwärmeseite 204 auf. Im Betrieb wirken die Peltierelemente 194 derart, dass Wärme von der Wärmeaufnahmeseite 202 zur Abwärmeseite 204 "gepumpt" wird (thermoelektrische Wärmepumpe).

Auf der Abwärmeseite 204 ist eine Fluidheizvorrichtung 206 vorgesehen, welche in Figur 2 lediglich symbolisch angedeutet ist und für deren Ausführung beispielsweise auf die Figur 3 verwiesen werden kann. Diese Fluidheizvorrichtung 206 ist mit dem Abstromende 184 der Kühlfluidleitung 180 verbunden, so dass die Fluidheizvorrichtung 206 von dem ersten Kühlfluid durchströmt werden kann. Die Fluidheizvorrichtung 206 steht in thermischem Kontakt mit der Abwärmeseite 204, so dass Wärme von dieser Abwärmeseite 204 auf das erste Kühlfluid übertragen werden kann. Über eine Ableitung 209 ist die Fluidheizvorrichtung 206 mit einem Fluidtank 207 verbunden. Dieser Fluidtank 207 kann beispielsweise als Boiler und/oder als Durchlauferhitzer ausgestaltet sein, kann jedoch auch ohne zusätzliche Heizvorrichtung ausgestaltet sein. Der Fluidtank 207 kann beispielsweise einer der oben beschriebenen Reinigungszonen 128, 132, 136, 138 zugeordnet sein, wobei eine Zuordnung zur Pumpenklarspülzone 136 und/oder zur Frischwasserklarspülzone 138 besonders bevorzugt ist. Insbesondere eine Zuordnung zur Frischwasserklarspülzone 138 ist von Vorteil, da hier die höchsten Temperaturen benötigt werden und da durch die Nutzung der Abwärme der feuchten Luft des Abluftstroms 162 zur Aufheizung des Fluidtanks 207 effizient eine Energieeinsparung vorgenommen werden kann.

Wie oben beschrieben ist hingegen der Wärmetauscherkreislauf 190 des zweiten Fluidwärmetauschers 186 als geschlossener Kreislauf ausgestaltet. Der Wärmetauscherkreislauf 190 ist verbunden mit einer Fluidkühlvorrichtung 208, welche in Figur 2 ebenfalls lediglich schematisch angedeutet ist und für deren beispielhafte Ausgestaltung auf Figur 3 verwiesen werden kann. In dieser Fluidkühlvorrichtung 208 kann zweites Wärmetauscherfluid, nach Durchströmen der zweiten Wärmetauscherflächen 188 und Aufnahme einer Wärmemenge aus dem Abluftstrom 162, diese aufgenommene zweite Wärmemenge an die Wärmeaufnahmeseite 202 der Peltierelemente 194 abgeben.

Die Wärmerückgewinnungseinrichtung 152 und deren Wärmetauscheinrichtung 156 sind also im vorliegenden Ausführungsbeispiel gemäß Figur 2 zweistufig ausgebildet. In dem ersten Fluidwärmetauscher 176 nimmt das durch die Kühlfluidleitung 180 strömende erste Kühlfluid eine erste Wärmemenge auf. In dem zweiten Fluidwärmetauscher 186 überträgt die feuchte Luft des nunmehr bereits leicht abgekühlten Abluftstroms 162 eine zweite Wärmemenge auf das durch den Wärmetauscherkreislauf 190 zirkulierende zweite Kühlfluid. Diese zweite Wärmemenge wird, zusätzlich zu Abwärmeleistungen der Peltierelemente 194 und abzüglich von Verlustwärmemengen durch die Peltierelemente 194, zusätzlich auf das durch die Kühlfluidleitung 180 strömende erste Kühlfluid übertragen, so dass dieses zusätzlich aufgeheizt wird.

Beispielsweise kann die feuchte Luft des Abluftstroms 162 vor Eintritt in die Wärmetauschereinrichtung 156 eine Temperatur im Bereich zwischen 80 und 90 °C aufweisen. Auf Seiten des Zustromendes 182 kann das erste Kühlfluid, beispielsweise Kaltwasser, eine Temperatur von beispielsweise 10 °C aufweisen. Auf Seiten des Abstromendes 184, also nach Durchtritt durch die ersten Wärmetauscherflächen 178, kann das erste Fluid auf eine Temperatur von ca. 60 °C aufgeheizt sein. Nach Durchtritt durch die Fluidheizvorrichtung 206 kann das erste Kühlfluid schließlich auf Temperaturen von 70 °C bis hin zu 85 °C oder mehr aufgeheizt sein, so dass eine optimale Temperatur in der Ableitung 209 zu dem Fluidtank 207 erreicht ist. Das zweite Kühlfluid in dem Wärmetauscherkreislauf 190 kann beispielsweise vor Durchströmen der zweiten Wärmetauscherflächen 188, bedingt durch die Kühlung in der Fluidkühlvorrichtung 208, eine Temperatur von ca. 10 °C aufweisen. In den zweiten Wärmetauscherflächen 188 wird dieses zweite Kühlfluid dann leicht erwärmt, beispielsweise auf eine Temperatur von 12 °C. Im Gegensatz zu reinen Flüssigkeitswärmetauschern reicht diese leichte Erwärmung und Aufnahme einer zweiten Wärmemenge aus, um durch die Peltierelemente 194 an das erste Kühlfluid übertragen zu werden. Abstromseitig kann der Abluftstrom 162 nach Austritt aus dem zweiten Fluidwärmetauscher 186 beispielsweise eine Temperatur von 15 °C einstellen. Diese Temperatur kann beispielsweise gesteuert und/oder geregelt werden, unabhängig von der Eingangstemperatur des Abluftstroms 162 und/oder unabhängig von der Eingangstemperatur des ersten Kühlfluids an dem Zustromende 182. Zu diesem Zweck kann die elektronische Steuervorrichtung 196 beispielsweise, entsprechend dem Signal des Temperatursensors 200, die Peltierelemente 194 entsprechend ansteuern, um die Kühlleistung zu erhöhen oder zu senken.

Es sei darauf hingewiesen, dass die genannten Zahlenwerte lediglich beispielhaft zu verstehen sind, und dass auch andere Ausgestaltungen der Temperaturen möglich sind. Alternativ oder zusätzlich zu der hier dargestellten zweistufigen Ausgestaltung der Wärmerückgewinnungseinrichtung 152 sind auch Kaskaden mit mehr als zwei Stufen denkbar, beispielsweise indem weitere Fluidwärmetauscher vorgesehen werden.

Die Kühlfluidleitung 180 weist in dem in Figur 2 dargestellten Ausführungsbeispiel einen ersten Abschnitt 226, einen zweiten Abschnitt 228, einen dritten Abschnitt 230, einen vierten Abschnitt 232, einen fünften Abschnitt 234, einen sechsten Abschnitt 236 und die Ableitung 209 auf.

Vom ersten Fluidwärmetauscher 176 herkommend, verzweigt sich der erste Abschnitt 226 der Kühlfluidleitung 180 an einem ersten Kreuzungspunkt 238 in den zweiten Abschnitt 228 und den fünften Abschnitt 234. In dem zweiten Abschnitt 228 ist die Fluidheizvorrichtung 206 aufgenommen. Anschließend an diese Fluidheizvorrichtung 206 gabelt sich der zweite Abschnitt 228 an einem zweiten Kreuzungspunkt 240 in den dritten Abschnitt 230 und den vierten Abschnitt 232. An einem dritten Kreuzungspunkt 242 gabelt sich der dritte Abschnitt 230 in die Ableitung 209 und den sechsten Abschnitt 236. Während die Ableitung 209 zum Fluidtank 207 (beispielsweise einem Boiler) führt, gabelt sich der sechste Abschnitt 236 an einem vierten Kreuzungspunkt 244 erneut in den vierten Abschnitt 232 und den fünften Abschnitt 234. Die Abschnitte können diverse Ventile aufweisen, mittels derer der Fluss durch diese Abschnitte gesteuert werden kann. Beispielhaft sind in der Ausführung in Figur 2 Ventile 246 (im ersten Abschnitt 226), 248 (im fünften Abschnitt 234), 250 (im vierten Abschnitt 232), 252 (im sechsten Abschnitt 236) und 254 (im dritten Abschnitt 230) vorgesehen. Auch eine andere Ausgestaltung der Ventile oder eine Zusammenfassung mehrerer Ventile (beispielsweise als Dreiwegeventile) ist denkbar. Weiterhin ist in dem Ausführungsbeispiel in Figur 2 in dem fünften Abschnitt 234 eine Pumpe 256 aufgenommen. Im vierten Abschnitt 232 ist ein Latentwärmespeicher 258 aufgenommen.

Weiterhin ist in Figur 2 angedeutet, dass die Kühlfluidleitung 180 mindestens zwei unterschiedliche Pfade bildet. So ist zum einen ein in Figur 2 strichpunktiert markierter Rückführpfad 260 vorgesehen sowie ein in Figur 2 punktiert dargestellter Wärmespeicherpfad 262. Während der Rückführpfad 260 die Abschnitte 226, 228, 230 und 209 umfasst und somit in diesem Ausführungsbeispiel als offener Pfad ausgestaltet ist, umfasst der Wärmespeicherpfad 262 die Abschnitte 228, 232 und 234 und ist somit als geschlossener Pfad bzw. geschlossener Kreislauf ausgebildet. Beide Pfade 260, 262 schließen die Fluidheizvorrichtung 206 ein. Der Wärmespeicherpfad 262 schließt darüber hinaus den Latentwärmespeicher 258 ein. Dieser Latentwärmespeicher 258 kann beispielsweise ein Wärmespeichermedium 264 der oben beschriebenen Art umfassen. Dieses Wärmespeichermedium 264 weist gemäß den oben beschriebenen Temperaturen vorzugsweise eine Übergangstemperatur beziehungsweise Umwandlungstemperatur im Bereich von ca. 70 °C auf, so dass dieses Wärmespeichermedium optimal die in dem ersten Kühlfluid nach Durchströmen der Fluidheizvorrichtung 206 gespeicherte Wärme aufnehmen kann. Der Latentwärmespeicher 258 kann konstruktiv beispielsweise gemäß einem der im Stand der Technik beschriebenen Latentwärmespeicher ausgeführt sein, beispielsweise gemäß dem in DE 37 41 652 A1 beschriebenen Latentwärmespeicher oder dem in DE 29 16 839 A1 beschriebenen Latentwärmespeicher. Auch andere konstruktive Ausgestaltungen sind jedoch möglich. Der Latentwärmespeicher 258 kann beispielsweise auch derart wärmeisoliert ausgestaltet sein, dass dieser die gespeicherte Wärmeenergie zumindest teilweise über einen vorgegebenen Zeitraum speichern kann. So kann beispielsweise die Isolierung, welche ein oder mehrere Isolationselemente umfassen kann, derart ausgestaltet sein, dass die Wärmeenergie beispielsweise über Nacht gespeichert bleiben kann und morgens zu Betriebsbeginn verwendet werden kann, beispielsweise im Rahmen eines Füllen und Aufheizens der Durchlaufgeschirrspülmaschine 112.

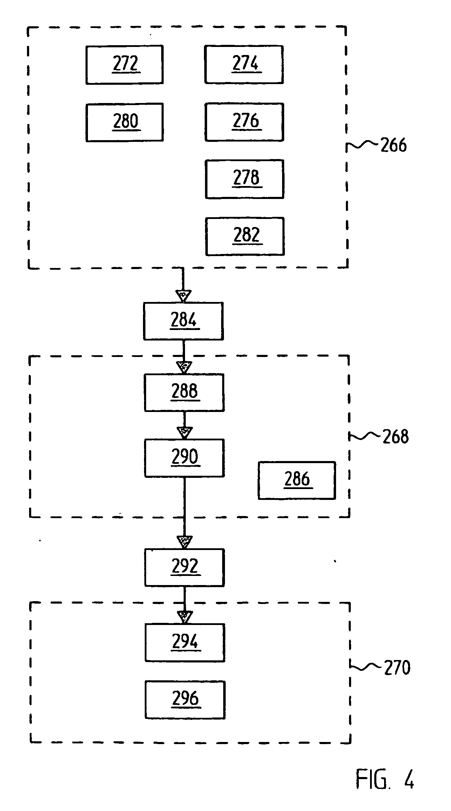

Um die Betriebsweise des Reinigungsgeräts 110 und insbesondere der Wärmerückgewinnungseinrichtung 152 näher zu erläutern, ist in Figur 4 stark schematisiert ein Ablaufdiagramm dargestellt, welches drei Betriebsphasen, nämlich einen Standby-Betrieb 266, eine Übergangsphase 268 und einen Betriebszustand 270 (auch Normalbetrieb genannt) umfasst. Natürlich kann jede dieser drei Betriebsphasen 268 bis 270 noch jeweils Unterphasen beinhalten, wobei beispielsweise der Normalbetrieb 270 mehrere Programmschritte umfassen kann, je nach Ausgestaltung des Reinigungsgeräts 110.

Im Standby-Betrieb 266 wird der Fluidtank 207, welcher beispielsweise als Boiler ausgestaltet ist, geheizt. Auch Maschinentanks der einzelnen Spülzonen, beispielsweise der Zonen 128, 132, können bereits auf Betriebstemperatur sein und können somit Dampfwrasen absondern. Damit wird das Reinigungsgerät 110 auf einen nachfolgenden Reinigungsvorgang vorbereitet, und es entstehen Dampfwrasen bzw. feuchte Luft, deren Abwärme in der Wärmetauscheinrichtung 256 rückgewonnen werden soll. Das Heizen des Fluidtanks 207 ist in Figur 4 symbolisch mit der Bezugsziffer 272 bezeichnet. Gleichzeitig sind im Standby-Betrieb 266 die Ventile 246, 252 und 254 geschlossen (Bezugsziffer 274), die Ventile 248 und 250 geöffnet (Bezugsziffer 276), und die Pumpe 256 ist im Betrieb (Bezugsziffer 278). Damit ist der Wärmespeicherpfad 262 aktiv (Bezugsziffer 280), und der Latentwärmespeicher 258 wird geladen (Bezugsziffer 282).

Es sei an dieser Stelle darauf hingewiesen, dass im Standby-Betrieb 266 der Latentwärmespeicher 258 nicht ausschließlich über das Peltierelement 194 geladen werden muss. Alternativ oder zusätzlich kann auch ein Aufwärmen dieses Latentwärmespeichers 258 oder eines weiteren Latentwärmespeichers (es können auch mehrere Latentwärmespeicher vorgesehen sein) unmittelbar durch einen oder mehrere Fluidwärmetauscher, beispielsweise den ersten Fluidwärmetauscher 176 und/oder den zweiten Fluidwärmetauscher 186, erfolgen. In diesem Fall können diese Fluidwärmetauscher beispielsweise ebenfalls in den geschlossenen Kreislauf des Wärmespeicherpfads 262 integriert werden. Mehrere Ausgestaltungen sind möglich. Die Ausgestaltung mit dem Peltierelement 194 ist jedoch besonders bevorzugt, da diese eine besonders effiziente Wärmeübertragung und insbesondere eine gleichmäßige Anpassung der Temperatur des ersten Kühlfluids auf die Übergangstemperatur des Wärmespeichermediums 264 ermöglicht.

In Schritt 284 wird der Standby-Betrieb 266 unterbrochen und ein Reinigungsbetrieb gestartet. Dies kann beispielsweise durch eine manuelle Benutzereingabe erfolgen und/oder auch automatisiert, beispielsweise wenn eine vorgegebene Temperatur in einem Fluidtank 207 erreicht ist. Dieser Programmschritt kann, wie auch die übrigen Programmschritte in Figur 4, ganz oder teilweise durch die zentrale Steuerung 196 und/oder eine andere elektronische Steuerung gesteuert werden, welche beispielsweise auch einen oder mehrere Computer umfassen kann.

Dementsprechend wird zunächst die Übergangsphase 268 eingeleitet. In dieser Übergangsphase 268 ist ein (in Figur 2 nicht gekennzeichneter) Übergangspfad aktiviert (Bezugsziffer 286), welcher sich hier aus den Abschnitten 226, 228, 232, 236 und 209 der Kühlfluidleitung 180 zusammensetzt. Zu diesem Zweck werden (Schritt 288) das Ventil 248 geschlossen, die Pumpe 256 gestoppt und die Ventile 246, 250 und 252 geöffnet. Dementsprechend wird der Latentwärmespeicher 258 über den oben beschriebenen Übergangspfad entladen (Bezugsziffer 290). Zu diesem Zweck kann mittels des ersten Kühlfluids die in diesem Latentwärmespeicher 258 enthaltene und gespeicherte Wärme in den Fluidtank 207 transportiert werden. Es sei darauf hingewiesen, dass auch andere Arten des Entladens des Latentwärmespeichers 258 als die in Figur 2 dargestellte Art möglich sind, so dass beispielsweise auch ein Entladen des Latentwärmespeichers 258 durch erstes Kühlfluid oder ein anderes Kühlfluid erfolgen kann, welches nicht zuvor die Fluidheizvorrichtung 206 durchströmt hat. Beispielsweise könnte auch ein Entladen über die Abschnitte 226, 234, 232, 230 und 209 erfolgen, wofür lediglich eine andere Ventilsteuerung als die in Figur 2 dargestellte Ventilsteuerung möglich ist. Auch ein Entladen über ein separates Kühlfluid wäre denkbar. Alternativ oder zusätzlich käme auch ein indirektes Entladen über einen weiteren Fluidkreislauf und/oder mittels eines weiteren Peltierelements in Betracht.

In Schritt 292 wird die Übergangsphase 268 beendet. Dies kann beispielsweise dadurch erfolgen, dass (beispielsweise mittels eines oder mehrerer Temperaturfühler, welche in Figur 2 nicht eingezeichnet sind) erkannt wird, dass Kühlfluid, welches den Latentwärmespeicher 258 durchströmt hat, nur noch unwesentlich durch diesen aufgeheizt wird. Auch ein Beendigen der Übergangsphase 268 nach einer fest vorgegebenen oder variablen Zeitdauer ist denkbar.

Nach der Beendigung der Übergangsphase 268 wird in den Normalbetrieb 270, das heißt in den Betriebszustand, umgeschaltet. Zu diesem Zweck werden die Ventile 250, 252 geschlossen, und das Ventil 254 geöffnet (alles Bezugsziffer 294 in Figur 4). Dementsprechend wird ein Normalbetrieb durchgeführt, in welchem der Rückführpfad 260 aktiv ist (Bezugsziffer 296) und somit dem Fluidtank 207 durch die Wärmerückgewinnungseinrichtung 152 wiedergewonnene Wärme aus der Abluft 162 wieder zugeführt wird.

Das in Figur 4 dargestellte Verfahren kann beliebig erweitert oder modifiziert werden. So kann sich beispielsweise ein erneuter Standby-Betrieb 266 anschließen, oder es können weitere, in Figur 4 nicht dargestellte Verfahrensschritte durchgeführt werden. Auch die in Figur 4 dargestellte zeitliche Reihenfolge ist zwar bevorzugt, ist jedoch nicht fest vorgegeben, so dass mehrere Verfahrensschritte beispielsweise auch parallel durchgeführt werden können und/oder dass beispielsweise auch einzelne Verfahrensschritte wiederholt oder in anderer Reihenfolge durchgeführt werden können.

In Figur 3 ist eine vergrößerte Darstellung der Peltierelemente 194 sowie der Fluidheizvorrichtung 206 und der Fluidkühlvorrichtung 208 gezeigt, welche beispielsweise in Figur 2 eingesetzt werden kann. Dabei ist gezeigt, dass die einzelnen Peltierelemente 194 in diesem Ausführungsbeispiel zu Peltierstapeln 210 zusammengesetzt sind. Jeder Peltierstapel 210 enthält in diesem Ausführungsbeispiel beispielhaft drei Peltierelemente 194, wobei diese Peltierelemente 194 derart zusammengesetzt sind, dass die jeweils eine Wärmeaufnahmeseite 202 eines ersten Peltierelements 194 an eine Abwärmeseite 204 eines benachbarten Peltierelements 194 angrenzt ("head-to-tail-Anordnung"). Auf diese Weise weist dementsprechend jeder Peltierstapel 210 eine Abwärmeseite 204 und eine Wärmeaufnahmeseite 202 auf. Die Anordnung mehrerer Peltierelemente 194 in Peltierstapeln 210 ermöglicht eine höhere Temperaturdifferenz zwischen Abwärmeseite 204 und Wärmeaufnahmeseite 202 als dies mit einzelnen Peltierelementen 194 möglich wäre. Bei dem Ausführungsbeispiel gemäß Figur 3 sind wiederum mehrere Peltierstapel 210 (in diesem Fall drei Peltierstapel 210) zu einem Peltiermodul 212 zusammengefasst. Dabei sind in diesem Ausführungsbeispiel die drei Peltierstapel 210 in einer "head-to-head"-Anordnung zueinander orientiert, so dass beispielsweise die Abwärmeseite 204 des linken Peltierstapels 210 der Abwärmeseite 204 des mittleren Peltierstapels 210 zuweist. Die Wärmeaufnahmeseite 202 des mittleren Peltierstapels 210 weist wiederum der Wärmeaufnahmeseite 202 des rechten Peltierstapels 210 zu. An den Außenseiten und zwischen den Peltierstapeln 210 sind dabei jeweils Tauscherplatten 214, 216 angeordnet, welche alternierend erste Wärmeaustauschbereiche 218 bzw. zweite Wärmeaustauschbereiche 220 bilden. Während die ersten Tauscherplatten 214 bzw. die ersten Wärmeaustauschbereiche 218 mit den Abwärmeseiten 204 der Peltierstapel 210 in thermischem Kontakt stehen, stehen die zweiten Tauscherplatten 216 bzw. die zweiten Wärmeaustauschbereiche 220 in thermischem Kontakt mit den Wärmeaufnahmeseiten 202 der Peltierstapel 210. Die Tauscherplatten 214, 216 weisen ersten bzw. zweite Hohlräume 222, 224 auf, welche von dem ersten Kühlfluid bzw. dem zweiten Kühlfluid durchflossen werden können. Entsprechend sind die ersten Hohlräume 222 mit der Kühlfluidleitung 180 bzw. der Ableitung 209 verbunden, wohingegen die zweiten Hohlräume 224 mit dem Wärmetauscherkreislauf 190 verbunden sind. Die ersten Wärmeaustauschbereiche 218 bilden somit die Fluidheizvorrichtung 206, wohingegen die zweiten Wärmeaustauschbereiche 220 die Fluidkühlvorrichtung 208 bilden.

Die Peltierstapel 210 und die Tauscherplatten 214, 216 können beispielsweise durch in Figur 3 nicht dargestellte Verbindungselemente zusammengehalten werden, beispielsweise Verschraubungen, Klammern oder ähnliches. Auf diese Weise kann eine effiziente Wärmeübertragung von dem zweiten Kühlfluid auf das erste Kühlfluid unter Zwischenschaltung der Peltierelemente 194 erfolgen.

Es sei darauf hingewiesen, dass die in Figur 3 dargestellte Anordnung der Peltierelemente 194 lediglich eines von vielen möglichen Ausführungsbeispielen darstellt. Auch andere Anordnungen sind denkbar, beispielsweise Anordnungen, in welchen mehrere Peltierelemente 194, alternativ oder zusätzlich zu einer Stapelung, nebeneinander angeordnet sind, um möglichst große Austauschflächen für eine Wärmeübertragung zu bilden. Auf diese Weise können Module hergestellt werden, welche beispielsweise Flächen mit Kantenlängen von einigen 10 cm bilden können. Neben der oben beschriebenen "head-to-head"-Anordnung sind auch nichtlineare Anordnungen, beispielsweise sternförmige Anordnungen, denkbar. Weiterhin kann auch eine andere Art der Durchströmung der Peltiermodule 212 gewählt werden, und es können weitere Vorrichtungen vorgesehen sein, um die Oberfläche zusätzlich zu erhöhen. Auf diese Weise lässt sich die Effizienz der Wärmeübertragung zusätzlich durch eine geeignete Anordnung verbessern.

### Bezugszeichenliste

- 110: Reinigungsgerät
- 112: Durchlaufgeschirrspülmaschine
- 114: Reinigungsgut
- 116: Durchlaufrichtung
- 118: Reinigungskammer
- 120: Transportband
- 122: Einlauf
- 124: Einlauftunnel
- 126: Trennvorhang
- 128: Vorspülzone
- 130: Vorspülsystem
- 132: Spülzone
- 134: Spülsystem
- 136: Pumpenklarspülzone
- 138: Frischwasserklarspülzone
- 140: Trocknungszone
- 142: Abnahmestrecke
- 144: Trocknungsgebläse
- 146: Austrittstrichter
- 148: Austrittsrichtung
- 150: Strömungsrichtung
- 152: Wärmerückgewinnungseinrichtung
- 154: Gebläse
- 156: Wärmetauscheinrichtung
- 158: Schacht
- 160: Abluftöffnung
- 162: Abluftstrom
- 164: Absaugstelle
- 166: Außenluftströme
- 168: Außenluftströme
- 170: Strömung
- 172: kleinere Luftmenge
- 174: größere Luftmenge
- 176: erster Fluidwärmetauscher
- 178: erste Wärmetauscherflächen
- 180: Kühlfluidleitung
- 182: Zustromende
- 184: Abstromende
- 186: zweiter Fluidwärmetauscher
- 188: zweite Wärmetauscherflächen
- 190: Wärmetauscherkreislauf
- 192: Pumpe
- 194: Peltierelemente
- 196: elektronische Steuervorrichtung
- 198: Steuerleitung
- 200: Temperatursensor
- 202: Wärmeaufnahmeseite
- 204: Abwärmeseite
- 206: Fluidheizvorrichtung
- 207: Fluidtank
- 208: Fluidkühlvorrichtung
- 209: Ableitung
- 210: Peltierstapel
- 212: Peltiermodul
- 214: erste Tauscherplatten
- 216: zweite Tauscherplatten
- 218: erste Wärmeaustauschbereiche
- 220: zweite Wärmeaustauschbereiche
- 222: erste Hohlräume
- 224: zweite Hohlräume
- 226: erster Abschnitt Kühlfluidleitung
- 228: zweiter Abschnitt Kühlfluidleitung
- 230: dritter Abschnitt Kühlfluidleitung
- 232: vierter Abschnitt Kühlfluidleitung
- 234: fünfter Abschnitt Kühlfluidleitung
- 236: sechster Abschnitt Kühlfluidleitung
- 238: erster Kreuzungspunkt
- 240: zweiter Kreuzungspunkt
- 242: dritter Kreuzungspunkt
- 244: vierter Kreuzungspunkt
- 246: Ventil
- 248: Ventil
- 250: Ventil
- 252: Ventil
- 254: Ventil
- 256: Pumpe
- 258: Latentwärmespeicher
- 260: Rückführpfad
- 262: Wärmespeicherpfad
- 264: Wärmespeichermedium
- 266: Standby-Betrieb
- 268: Übergangsphase
- 270: Normalbetrieb, Betriebszustand
- 272: Heizen Fluidtank
- 274: Ventile 246, 252, 254 geschlossen
- 276: Ventile 248, 250 geöffnet
- 278: Pumpe läuft
- 280: Wärmespeicherpfad aktiv
- 282: Latentwärmespeicher wird geladen
- 284: Reinigungsbetrieb starten
- 286: Übergangspfad aktiviert
- 288: Ventil 248 schließen, Pumpe 256 stoppen, Ventile 246, 252 öffnen
- 290: Latentwärmespeicher entladen
- 292: Beenden Übergangsphase
- 294: Ventile 250, 252 schließen, Ventil 254 öffnen
- 296: Rückführpfad aktiv

## Patentansprüche

1. Reinigungsgerät (110) zur Reinigung von Reinigungsgut (114), wobei das Reinigungsgerät (110) eingerichtet ist, um das Reinigungsgut (114) in mindestens einer Reinigungskammer (118) mit mindestens einem Reinigungsfluid zu beaufschlagen, wobei das Reinigungsgerät (110) eine Absaugvorrichtung (154) zum Absaugen von feuchter Luft aus der Reinigungskammer (118) aufweist, wobei das Reinigungsgerät (110) mindestens eine Wärmerückgewinnungseinrichtung (152) aufweist, wobei die Wärmerückgewinnungseinrichtung (152) eingerichtet ist, um der feuchten Luft Wärme zu entziehen und dem Reinigungsgerät (110) über ein erstes Kühlfluid wieder zuzuführen, **dadurch gekennzeichnet, dass** das Reinigungsgerät (110) eine Kühlfluidleitung (180) mit mindestens einem Rückführpfad (260) sowie mindestens einem Wärmespeicherpfad (262) mit mindestens einem Latentwärmespeicher (258) aufweist, wobei das Reinigungsgerät (110) eingerichtet ist, um das erste Kühlfluid in mindestens einem Betriebszustand (270) nach Durchströmen der Wärmerückgewinnungseinrichtung (152) über den Rückführpfad (260) zu der Reinigungskammer (118) und/oder in einen Fluidtank (207) zu leiten, wobei das Reinigungsgerät (110) weiterhin eingerichtet ist, um das erste Kühlfluid in mindestens einem Standby-Betrieb (266) über den Wärmespeicherpfad (262) dem Latentwärmespeicher (258) zuzuführen.

2. Reinigungsgerät (110) nach dem vorhergehenden Anspruch, wobei der Latentwärmespeicher (258) ein mehrstufiger Latentwärmespeicher (258) mit mindestens zwei Übergangstemperaturen ist.

3. Reinigungsgerät (110) nach einem der vorhergehenden Ansprüche, wobei der Latentwärmespeicher (258) mindestens eines der folgenden Wärmespeichermaterialien (264) aufweist: ein Salz; ein Paraffin; Natriumacetat-Trihydrat; Acetamid; t-Crotonsäure; Tristearin; Kaliumaluminiumsulfat, insbesondere in Hydratform; Natriumaluminiumsulfat, insbesondere in Hydratform; Magnesiumnitrat, insbesondere in Hydratform.

4. Reinigungsgerät (110) nach einem der vorhergehenden Ansprüche, wobei der Latentwärmespeicher (258) mindestens eine Übergangstemperatur im Bereich zwischen 30 °C und 90 °C, insbesondere im Bereich zwischen 50 °C und 80 °C und besonders bevorzugt bei 70 °C aufweist.

5. Reinigungsgerät (110) nach einem der vorhergehenden Ansprüche, wobei der Wärmespeicherpfad (262) als geschlossener Kreislauf ausgestaltet ist, in dem im Standby-Betrieb (266) das erste Kühlfluid zwischen der Wärmerückgewinnungseinrichtung (152) und dem Latentwärmespeicher (258) zirkulieren kann.

6. Reinigungsgerät (110) nach einem der vorhergehenden Ansprüche, wobei das Reinigungsgerät eingerichtet ist, um nach dem Standby-Betrieb eine Übergangsphase einzuleiten, in welcher die in dem Latentwärmespeicher (258) gespeicherte Wärme ganz oder teilweise zu der Reinigungskammer (118) und/oder in den Fluidtank (207) überführt wird.

7. Reinigungsgerät (110) nach einem der vorhergehenden Ansprüche, wobei die Wärmerückgewinnungseinrichtung (152) mindestens eine thermoelektrische Wärmepumpe und/oder mindestens eine thermomechanische Wärmepumpe aufweist.

8. Reinigungsgerät (110) nach dem vorhergehenden Anspruch, wobei die thermoelektrische Wärmepumpe mindestens ein Peltierelement (194) aufweist, wobei das Peltierelement (194) eine Wärmeaufnahmeseite (202) und eine Abwärmeseite (204) aufweist, wobei die Abwärmeseite (204) mit einer Fluidheizvorrichtung (206) in thermischem Kontakt steht, wobei die Fluidheizvorrichtung (206) vom dem einen ersten Kühlfluid durchströmt wird, wobei das erste Kühlfluid nach Durchströmen der Fluidheizvorrichtung (206) in den Rückführpfad (260) und/oder in den Wärmespeicherpfad (262) geführt wird.

9. Reinigungsgerät (110) nach dem vorhergehenden Anspruch, wobei die Wärmerückgewinnungseinrichtung (152) mindestens einen ersten Fluidwärmetauscher (176) aufweist, wobei der erste Fluidwärmetauscher (176) eingerichtet ist, um der feuchten Luft eine erste Wärmemenge zu entziehen, wobei die Wärmeaufnahmeseite (202) des Peltierelements (194) eingerichtet ist, um der feuchten Luft eine zweite Wärmemenge zu entziehen.

10. Reinigungsgerät (110) nach dem vorhergehenden Anspruch, wobei der erste Fluidwärmetauscher (176) von dem ersten Kühlfluid durchströmt wird, wobei das erste Kühlfluid nach Durchströmen des ersten Fluidwärmetauschers (176) die Fluidheizvorrichtung (206) durchströmt.

11. Reinigungsgerät (110) nach einem der Ansprüche 8-10, wobei die Wärmerückgewinnungseinrichtung (152) weiterhin mindestens einen zweiten Fluidwärmetauscher (186) aufweist, wobei der zweite Fluidwärmetauscher (186) von einem zweiten Kühlfluid durchströmt wird, wobei das zweite Kühlfluid in mindestens einer Fluidkühlvorrichtung (208) in thermischem Kontakt mit der Wärmeaufnahmeseite (202) des Peltierelements (194) steht.

12. Reinigungsgerät (110) nach dem vorhergehenden Anspruch, wobei der zweite Fluidwärmetauscher (186) einen von dem zweiten Kühlfluid durchströmten Wärmetauscherkreislauf (190) aufweist, wobei der Wärmetauscherkreislauf mindestens einen mit der feuchten Luft in Kontakt stehenden Wärmetauscherbereich (188) und die Fluidkühlvorrichtung (208) umfasst.

13. Reinigungsgerät (110) nach einem der Ansprüche 11-12, wobei mehrere Peltierelemente (194) kaskadenartig in Peltierstapeln (210) mit je einer Wärmeaufnahmeseite (202) und je einer Abwärmeseite (204) gestapelt angeordnet sind.

14. Reinigungsgerät (110) nach dem vorhergehenden Anspruch, wobei mehrere Peltierstapel (210) bezüglich ihrer Wärmeaufnahmeseiten (202) und ihrer Abwärmeseiten (204) alternierend angeordnet sind und zu einem Peltiermodul (212) zusammengefasst sind, wobei zwischen den Peltierstapeln (210) jeweils Wärmeaustauschbereiche angeordnet sind, wobei jeweils mindestens ein erster Wärmeaustauschbereich (218) mit mindestens zwei Abwärmeseiten (204) der Peltierstapel (210) in thermischem Kontakt steht und wobei jeweils mindestens ein zweiter Wärmeaustauschbereich (220) mit mindestens zwei Wärmeaufnahmeseiten (202) der Peltierstapel (210) in thermischem Kontakt steht.

15. Reinigungsgerät (110) nach dem vorhergehenden Anspruch, wobei der erste Wärmeaustauschbereich (218) und/oder der zweite Wärmeaustauschbereich (220) mindestens einen Hohlraum (222, 224) umfassen.

16. Reinigungsgerät (110) nach einem der vorhergehenden Ansprüche, wobei das Reinigungsgerät (110) mindestens eine Durchlaufgeschirrspülmaschine (112) mit mindestens einer Reinigungszone (128, 132, 136, 138) umfasst, wobei die Durchlaufgeschirrspülmaschine (112) derart eingerichtet ist, dass das Reinigungsgut (114) die Reinigungszone (128, 132, 136, 138) in einer Durchlaufrichtung (116) durchläuft, wobei die mindestens eine Reinigungszone (128, 132, 136, 138) mindestens eine Klarspülzone (136, 138) mit mindestens einem Klarspültank umfasst, wobei das erste Kühlfluid nach Durchströmen der Fluidheizvorrichtung (206) in den Klarspültank geleitet wird.

17. Verfahren zur Wärmerückgewinnung in einem Reinigungsgerät (110) nach einem der vorhergehenden Ansprüche, wobei das Reinigungsgerät (110) eingerichtet ist, um das Reinigungsgut (114) in mindestens einer Reinigungskammer (118) mit mindestens einem Reinigungsfluid zu beaufschlagen, wobei das Reinigungsgerät (110) eine Absaugvorrichtung (154) zum Absaugen von feuchter Luft aus der Reinigungskammer (118) aufweist, wobei das Reinigungsgerät (110) mindestens eine Wärmerückgewinnungseinrichtung (152) aufweist, wobei die Wärmerückgewinnungseinrichtung (152) eingerichtet ist, um der feuchten Luft Wärme zu entziehen und dem Reinigungsgerät (110) über ein erstes Kühlfluid wieder zuzuführen, **dadurch gekennzeichnet, dass** das Reinigungsgerät (110) eine Kühlfluidleitung (180) mit mindestens einem Rückführpfad (260) sowie mindestens einem Wärmespeicherpfad (262) mit mindestens einem Latentwärmespeicher (258) aufweist, wobei das erste Kühlfluid in mindestens einem Betriebszustand (270) nach Durchströmen der Wärmerückgewinnungseinrichtung (152) über den Rückführpfad (260) zu der Reinigungskammer (118) und/oder in einen Fluidtank (207) geleitet wird und wobei das erste Kühlfluid in mindestens einem Standby-Betrieb (266) über den Wärmespeicherpfad (262) dem Latentwärmespeicher (258) zugeführt wird.

## Claims

1. Cleaning apparatus (110) for cleaning articles to be cleaned (114), wherein the cleaning apparatus (110) is designed to subject the articles to be cleaned (114), in at least one cleaning chamber (118), to at least one cleaning fluid, wherein the cleaning apparatus (110) has an extractor (154) for extracting moist air from the cleaning chamber (118), wherein the cleaning apparatus (110) has at least one heat recovery device (152), and wherein the heat recovery device (152) is designed to extract heat from the moist air and re-supply it to the cleaning apparatus (110) via a first cleaning fluid, **characterized in that** the cleaning apparatus (110) has a cooling fluid line (180) having at least one return path (260), as well as at least one heat storage path (262) having at least one latent heat reservoir (258), wherein the cleaning apparatus (110) is designed to lead the first cooling fluid, in at least one operating mode (270), after having flowed through the heat recovery device (152), via the return path (260) to the cleaning chamber (118) and/or into a fluid tank (207), and wherein the cleaning apparatus (110) is additionally designed to supply the first cooling fluid, in at least one standby operation (266), to the latent heat reservoir (258) via the heat storage path (262).

2. Cleaning apparatus (110) according to the preceding claim, wherein the latent heat reservoir (258) is a multi-stage latent heat reservoir (258) having at least two transition temperatures.

3. Cleaning apparatus (110) according to one of the preceding claims, wherein the latent heat reservoir (258) has at least one of the following heat storage materials (264): a salt; a paraffin; a sodium acetate trihydrate; acetamide; t-crotonic acid; tristearin; aluminium potassium sulphate, in particular in hydrate form; aluminium sodium sulphate, in particular in hydrate form, magnesium nitrate, in particular in hydrate form.

4. Cleaning apparatus (110) according to one of the preceding claims, wherein the latent heat reservoir (258) has at least one transition temperature in the range between 30°C and 90°C, in particular in the range between 50°C and 80°C, and particularly preferably at around 70°C.

5. Cleaning apparatus (110) according to one of the preceding claims, wherein the heat storage path (262) is configured as a closed circuit, in which, in standby operation (266), the first cooling fluid can circulate between the heat recovery device (152) and the latent heat reservoir (258).

6. Cleaning apparatus (110) according to one of the preceding claims, wherein the cleaning apparatus is designed to, after the standby operation, induce a transitional phase in which the heat stored in the latent heat reservoir (258) is transferred wholly or partially to the cleaning chamber (118) and/or into the fluid tank (207).

7. Cleaning apparatus (110) according to one of the preceding claims, wherein the heat recovery device (152) has at least one thermoelectric heat pump and/or at least one thermomechanical heat pump.

8. Cleaning apparatus (110) according to one of the preceding claims, wherein the thermoelectric heat pump has at least one Peltier element (194), wherein the Peltier element (194) has a heat take-up side (202) and a heat loss side (204), wherein the heat loss side (204) is in thermal contact with a fluid heating apparatus (206), wherein the fluid heating apparatus (206) is flowed through by the one first cooling fluid, and wherein the first cooling fluid, after having flowed through the fluid heating apparatus (206), is guided into the return path (260) and/or into the heat storage path (262).

9. Cleaning apparatus (110) according to one of the preceding claims, wherein the heat recovery device (152) has at least a first fluid heat exchanger (176), wherein the first fluid heat exchanger (176) is designed to extract a first heat quantity from the moist air, and wherein the heat take-up side (202) of the Peltier element (194) is designed to extract a second heat quantity from the moist air.

10. Cleaning apparatus (110) according to the preceding claim, wherein the first fluid heat exchanger (176) is flowed through by the first cooling fluid, and wherein the first cooling fluid, after having flowed through the first fluid heat exchanger (176), flows through the fluid heating apparatus (206).

11. Cleaning apparatus (110) according to one of Claims 8-10, wherein the heat recovery device (152) further has at least a second fluid heat exchanger (186), wherein the second fluid heat exchanger (186) is flowed through by a second cooling fluid, and wherein the second cooling fluid, in at least one fluid cooling apparatus (208), is in thermal contact with the heat take-up side (202) of the Peltier element (194).

12. Cleaning apparatus (110) according to the preceding claim, wherein the second fluid heat exchanger (186) has a heat exchanger circuit (190) flowed through by the second cooling fluid, wherein the heat exchanger circuit comprises at least one heat exchanger region (188), which is in contact with the moist air, and the fluid cooling apparatus (208).

13. Cleaning apparatus (110) according to one of Claims 11-12, wherein a plurality of Peltier elements (194) are arranged stacked in a cascade-like manner in Peltier stacks (210) having, in each case, a heat take-up side (202) and a heat loss side (204).

14. Cleaning apparatus (110) according to the preceding claim, wherein a plurality of Peltier stacks (210) are arranged alternately with respect to their heat take-up side (202) and their heat loss side (204) and are combined into a Peltier module (212), wherein heat exchange regions are respectively disposed between the Peltier stacks (210), wherein respectively at least a first heat exchange region (218) is in thermal contact with at least two heat loss sides (204) of the Peltier stacks (210), and wherein respectively at least a second heat exchange region (220) is in thermal contact with at least two heat take-up sides (202) of the Peltier stacks (210).

15. Cleaning apparatus (110) according to the preceding claim, wherein the first heat exchange region (218) and/or the second heat exchange region (220) comprise at least one cavity (222, 224).

16. Cleaning apparatus (110) according to one of the preceding claims, wherein the cleaning apparatus (110) comprises at least one continuous flow dishwasher (112) having at least one cleaning zone (128, 132, 136, 138), wherein the continuous flow dishwasher (112) is designed such that the articles to be cleaned (114) pass through the cleaning zone (128, 132, 136, 138) in a traversing direction (116), wherein the at least one cleaning zone (128, 132, 136, 138) comprises at least one clear rinse zone (136, 138) having at least one clear rinse tank, and wherein the first cooling fluid, after having flowed through the fluid heating apparatus (206), is led into the clear rinse tank.

17. Method for heat recovery in a cleaning apparatus (110) according to one of the preceding claims, wherein the cleaning apparatus (110) is designed to subject the articles to be cleaned (114), in at least one cleaning chamber (118), to at least one cleaning fluid, wherein the cleaning apparatus (110) has an extractor (154) for extracting moist air from the cleaning chamber (118), wherein the cleaning apparatus (110) has at least one heat recovery device (152), and wherein the heat recovery device (152) is designed to extract heat from the moist air and re-supply it to the cleaning apparatus (110) via a first cleaning fluid, **characterized in that** the cleaning apparatus (110) has a cooling fluid line (180) having at least one return path (260), as well as at least one heat storage path (262) having at least one latent heat reservoir (258), wherein the first cooling fluid, in at least one operating state (270), after having flowed through the heat recovery device (152), is led via the return path (260) to the cleaning chamber (118) and/or into a fluid tank (207), and wherein the first cooling fluid, in at least one standby operation (266), is supplied to the latent heat reservoir (258) via the heat storage path (262).

## Revendications

1. Appareil de nettoyage (110) pour nettoyer un produit à nettoyer (114), l'appareil de nettoyage (110) étant prévu pour solliciter le produit à nettoyer (114) dans au moins une chambre de nettoyage (118) avec au moins un fluide de nettoyage, l'appareil de nettoyage (110) présentant un dispositif d'aspiration (154) pour aspirer l'air humide de la chambre de nettoyage (118), l'appareil de nettoyage (110) présentant au moins un dispositif de récupération de chaleur (152), le dispositif de récupération de chaleur (152) étant prévu pour prélever de la chaleur de l'air humide et l'acheminer à nouveau à l'appareil de nettoyage (110) par le biais d'un premier fluide de refroidissement, **caractérisé en ce que** l'appareil de nettoyage (110) présente une conduite de fluide de refroidissement (180) avec au moins un chemin de retour (260) et au moins un chemin d'accumulateur de chaleur (262) avec au moins un accumulateur de chaleur latente (258), l'appareil de nettoyage (110) étant prévu pour guider le premier fluide de refroidissement dans au moins un état de fonctionnement (270) après le passage à travers le dispositif de récupération de chaleur (152) par le biais du chemin de retour (260) jusqu'à la chambre de nettoyage (118) et/ou dans un réservoir de fluide (207), l'appareil de nettoyage (110) étant en outre prévu pour acheminer le premier fluide de refroidissement dans au moins un fonctionnement en mode d'attente (266) par le biais du chemin d'accumulateur de chaleur (262) à l'accumulateur de chaleur latente (258).

2. Appareil de nettoyage (110) selon la revendication précédente, dans lequel l'accumulateur de chaleur latente (258) est un accumulateur de chaleur latente à plusieurs étages (258) avec au moins deux températures de transition.

3. Appareil de nettoyage (110) selon l'une quelconque des revendications précédentes, dans lequel l'accumulateur de chaleur latente (258) présente au moins l'un des matériaux d'accumulateur de chaleur (264) suivants : un sel ; une paraffine ; de l'acétate de sodium trihydraté ; de l'acétamide ; de l'acide t-crotonique ; de la tristéarine ; du sulfate d'aluminium et de potassium, en particulier sous forme hydratée ; du sulfate d'aluminium et de sodium, en particulier sous forme hydratée ; du nitrate de magnésium, en particulier sous forme hydratée.

4. Appareil de nettoyage (110) selon l'une quelconque des revendications précédentes, dans lequel l'accumulateur de chaleur latente (258) présente au moins une température de transition dans la plage comprise entre 30°C et 90°C, notamment dans la plage comprise entre 50°C et 80°C, et particulièrement préférablement de l'ordre de 70°C.

5. Appareil de nettoyage (110) selon l'une quelconque des revendications précédentes, dans lequel le chemin d'accumulateur de chaleur (262) est réalisé sous forme de circuit fermé, dans lequel, dans le mode de fonctionnement d'attente (266), le premier fluide de refroidissement peut circuler entre le dispositif de récupération de chaleur (152) et l'accumulateur de chaleur latente (258).

6. Appareil de nettoyage (110) selon l'une quelconque des revendications précédentes, dans lequel l'appareil de nettoyage est prévu pour amorcer une phase de transition après le mode de fonctionnement d'attente, dans laquelle la chaleur accumulée dans l'accumulateur de chaleur latente (258) est complètement ou partiellement transférée à la chambre de nettoyage (118) et/ou au réservoir de fluide (207).

7. Appareil de nettoyage (110) selon l'une quelconque des revendications précédentes, dans lequel le dispositif de récupération de chaleur (152) présente au moins une pompe à chaleur thermoélectrique et/ou au moins une pompe à chaleur thermomécanique.

8. Appareil de nettoyage (110) selon la revendication précédente, dans lequel la pompe à chaleur thermoélectrique présente au moins un élément Peltier (194), l'élément Peltier (194) présentant un côté d'absorption de la chaleur (202) et un côté de dégagement de chaleur (204), le côté de dégagement de chaleur (204) étant en contact thermique avec un dispositif de chauffage de fluide (206), le dispositif de chauffage de fluide (206) étant parcouru par le premier fluide de refroidissement, le premier fluide de refroidissement étant guidé après son passage à travers le dispositif de chauffage de fluide (206) dans le chemin de retour (260) et/ou dans le chemin d'accumulateur de chaleur (262).

9. Appareil de nettoyage (110) selon la revendication précédente, dans lequel le dispositif de récupération de chaleur (152) présente au moins un premier échangeur de chaleur fluidique (176), le premier échangeur de chaleur fluidique (176) étant prévu pour prélever une première quantité de chaleur de l'air humide, le côté d'absorption de chaleur (202) de l'élément Peltier (194) étant prévu pour prélever une deuxième quantité de chaleur de l'air humide.

10. Appareil de nettoyage (110) selon la revendication précédente, dans lequel le premier échangeur de chaleur fluidique (176) est parcouru par le premier fluide de refroidissement, le premier fluide de refroidissement s'écoulant à travers le dispositif de chauffage de fluide (206) après son passage à travers le premier échangeur de chaleur fluidique (176).

11. Appareil de nettoyage (110) selon l'une quelconque des revendications 8 à 10, dans lequel le dispositif de récupération de chaleur (152) présente en outre au moins un deuxième échangeur de chaleur fluidique (186), le deuxième échangeur de chaleur fluidique (186) étant parcouru par un deuxième fluide de refroidissement, le deuxième fluide de refroidissement dans au moins un dispositif de refroidissement de fluide (208) étant en contact thermique avec le côté d'absorption de chaleur (202) de l'élément Peltier (194).

12. Appareil de nettoyage (110) selon la revendication précédente, dans lequel le deuxième échangeur de chaleur fluidique (186) présente un circuit d'échangeur de chaleur (190) parcouru par le deuxième fluide de refroidissement, le circuit d'échangeur de chaleur comprenant au moins une région d'échangeur de chaleur (188) en contact avec l'air humide, et le dispositif de refroidissement de fluide (208).

13. Appareil de nettoyage selon l'une quelconque des revendications 11 à 12, dans lequel plusieurs éléments Peltier (194) sont empilés en cascade en empilements de Peltier (210) avec un côté d'absorption de chaleur respectif (202) et un côté de dégagement de chaleur respectif (204).

14. Appareil de nettoyage (110) selon la revendication précédente, dans lequel plusieurs empilements de Peltier (210) sont disposés en alternance sur leurs côtés d'absorption de chaleur (202) et leurs côtés de dégagement de chaleur (204), et sont réunis en un module Peltier (212), des régions d'échange de chaleur étant à chaque fois disposées entre les empilements de Peltier (210), au moins une première région d'échange de chaleur (218) étant à chaque fois au moins en contact thermique avec au moins deux côtés de dégagement de chaleur (204) de l'empilement de Peltier (210) et à chaque fois au moins une deuxième région d'échange de chaleur (220) étant en contact thermique avec au moins deux côtés d'absorption de chaleur (202) de l'empilement de Peltier (210).

15. Appareil de nettoyage (110) selon la revendication précédente, dans lequel la première région d'échange de chaleur (218) et/ou la deuxième région d'échange de chaleur (220) comprennent au moins une cavité (222, 224).

16. Appareil de nettoyage (110) selon l'une quelconque des revendications précédentes, dans lequel l'appareil de nettoyage (110) comprend au moins un lave-vaisselle continu (112) avec au moins une zone de nettoyage (128, 132, 136, 138), le lave-vaisselle continu (112) étant prévu de telle sorte que le produit à nettoyer (114) traverse la zone de nettoyage (128, 132, 136, 138) dans une direction d'avance (116), l'au moins une zone de nettoyage (128, 132, 136, 138) comprenant au moins une zone de rinçage claire (136, 138) avec au moins un réservoir de rinçage clair, le premier fluide de refroidissement étant guidé dans le réservoir de rinçage clair après son passage à travers le dispositif de chauffage de fluide (206).

17. Procédé de récupération de chaleur dans un appareil de nettoyage (110) selon l'une quelconque des revendications précédentes, dans lequel l'appareil de nettoyage (110) est prévu pour solliciter le produit à nettoyer (114) dans au moins une chambre de nettoyage (118) avec au moins un fluide de nettoyage, l'appareil de nettoyage (110) présentant un dispositif d'aspiration (154) pour aspirer l'air humide de la chambre de nettoyage (118), l'appareil de nettoyage (110) présentant au moins un dispositif de récupération de chaleur (152), le dispositif de récupération de chaleur (152) étant prévu pour prélever de la chaleur de l'air humide et l'acheminer à nouveau à l'appareil de nettoyage (110) par le biais d'un premier fluide de refroidissement, **caractérisé en ce que** l'appareil de nettoyage (110) présente une conduite de fluide de refroidissement (180) avec au moins un chemin de retour (260) et au moins un chemin d'accumulateur de chaleur (262) avec au moins un accumulateur de chaleur latente (258), le premier fluide de refroidissement étant guidé dans au moins un état de fonctionnement (270) après son passage à travers le dispositif de récupération de chaleur (152) par le biais du chemin de retour (260) jusqu'à la chambre de nettoyage (118) et/ou dans un réservoir de fluide (207) et le premier fluide de refroidissement étant acheminé dans au moins un mode de fonctionnement d'attente (266) par le biais du chemin d'accumulateur de chaleur (262) à l'accumulateur de chaleur latente (258).
